# EUROPEAN PATENT APPLICATION

(11) **EP 4 745 971 A1**
(43) Date of publication of application: **20.05.2026**
(21) Application number: 25216784.6
(22) Date of filing: 18.11.2025
(51) Int. Cl.: G11C 16/10, G11C 16/34, G11C 11/56

(54) **STORAGE DEVICE, STORAGE SYSTEM INCLUDING THE SAME, AND OPERATING METHOD THEREOF**

(30) Priority: 19.11.2024 KR 20240165186
(71) Applicant: Samsung Electronics Co., Ltd., Suwon-si, Gyeonggi-do 16677 (KR)
(72) Inventor: PARK, Byungchan, 16677 Suwon-si (KR); PARK, Jeongkeun, 16677 Suwon-si (KR); KANG, Hee-Woong, 16677 Suwon-si (KR); KIM, Yeonji, 16677 Suwon-si (KR); OH, Heejun, 16677 Suwon-si (KR); YOO, Sangjin, 16677 Suwon-si (KR)
(74) Representative: Marks & Clerk LLP

(57) **Abstract**

A storage device includes a memory device and a storage controller. The memory device includes a memory cell array having a memory block with a plurality of pages to which memory cells are connected, and a control logic circuit. The storage controller obtains information on the memory block, determines a number of pages on which a program operation that skips a verification procedure is to be performed based on the obtained information, and transmits a program command for the program operation to the memory device. In response, the memory device receives the program command and performs the program operation by executing a single program loop without a verification procedure for at least one page indicated by the program command among the plurality of pages.

## Description

### BACKGROUND

### TECHNICAL FIELD

The present disclosure relates to a storage device, a storage system including the same, and an operating method thereof.

### DESCRIPTION OF THE RELATED ART

Semiconductor memories can be classified into volatile memory devices that lose stored data when power is cut off, such as a static RAM (SRAM), a dynamic RAM (DRAM), and a synchronous DRAM (SDRAM), and nonvolatile memory devices that retain stored data even when power is cut off, such as a read only memory (ROM), a programmable ROM (PROM), an electrically programmable ROM (EPROM), an electrically erasable and programmable ROM (EEPROM), a flash memory device, a phase-change RAM (PRAM), a magnetic RAM (MRAM), a resistive RAM (RRAM), and a ferroelectric RAM (FRAM).

Memory devices can be widely used as mass storage media for computing systems. The memory devices may be designed to communicate with a storage controller based on various electrical signals.

The above-mentioned information is intended to improve understanding of the background of the present disclosure and may include information not contained in a related art.

### SUMMARY

The present disclosure relates to a storage device for shortening the programming time of a memory device, a storage system including the same, and an operating method thereof.

The problems to be resolved by the present disclosure are not limited to those described above, and the following description of the present disclosure would allow a person having ordinary skill in the art to clearly understand other problems not mentioned above.

A storage device according to one embodiment of the present disclosure includes a memory device including a memory cell array including a memory block having a plurality of pages to which memory cells are connected and a control logic circuit and a storage controller that obtains information on the memory block, determines the number of pages on which a first program operation for skipping a verification procedure is to be performed based on the obtained information on the memory block, and transmits a first program command for the first program operation to the memory device. The memory device receives the first program command from the storage controller and performs the first program operation by executing one program loop for skipping a verification procedure for a page indicated by the first program command among the plurality of pages.

A storage device according to one embodiment of the present disclosure includes a memory device including a memory cell array including a memory block having a plurality of pages to which memory cells are connected and a control logic circuit and a storage controller transmitting, to the memory device, a program command for a program operation for each of the plurality of pages. The memory device obtains information on the memory block, determines the number of pages on which a program operation for skipping a verification procedure is to be performed based on the information on the memory block, receives the program command from the storage controller, and performs the program operation by executing one program loop for skipping a verification procedure for pages corresponding to the number of pages and indicated by the program command.

An operating method of a storage system according to one embodiment of the present disclosure is performed by the storage system that includes a memory device including a memory cell array including a memory block having a plurality of pages and a control logic circuit, a storage controller exchanging data with the memory device, and a host device exchanging data with the storage controller. The operating method of the storage system includes obtaining information on the memory block by the storage system; determining, by the storage system, the number of pages on which a program operation for skipping a verification procedure is to be performed based on the obtained information on the memory block; transmitting, by the storage controller, a program command for a program operation for each of the plurality of pages to the memory device; receiving the program command by the memory device; and performing, by the memory device, the program operation by executing one program loop for skipping a verification procedure for pages corresponding to the number of pages and indicated by the program command.

According to various embodiments of the present disclosure, it may be possible to shorten the time taken to perform a program operation on a memory block.

According to various embodiments of the present disclosure, it may be possible to minimize failures in program operations by flexibly adjusting the count of fast programs based on a range of factors while reducing the time taken to execute programs for memory blocks. As a result, the writing speed of the memory device may be enhanced, and the throughput thereof may be increased.

According to various embodiments of the present disclosure, power consumption required to perform program operations may be reduced, and the stress applied to memory cells may decrease, thereby extending the life of the memory device.

The effects of the present disclosure are not limited to those described above. The following description of the present disclosure would allow a person having ordinary skill in the art to clearly understand other technical effects thereof not mentioned above.

At least some of the above and other features of the invention are set out in the claims.

### BRIEF DESCRIPTION OF THE DRAWINGS

FIG. 1 shows a storage system according to one embodiment of the present disclosure.
FIG. 2 is a view for illustrating a nonvolatile memory according to one embodiment of the present disclosure.
FIG. 3 is a perspective view of a memory block according to one embodiment of the present disclosure.
FIG. 4 is a circuit diagram of the memory block according to one embodiment of the present disclosure.
FIG. 5 shows a series of program voltages for programming memory cells with multi-level data according to one embodiment of the present disclosure.
FIG. 6 is a view for illustrating states of a plurality of memory cells according to some embodiments of the present disclosure.
FIG. 7 shows an operating method of a storage system according to one embodiment of the present disclosure.
FIG. 8A shows components of a storage system that performs the operating method of the storage system in FIG. 7.
FIGS. 8B to 8D show various examples of the positions of the components in FIG. 8A on the storage system.
FIG. 9 is a flowchart for illustrating S710 in FIG. 7 in detail.
FIGS. 10A and 10B are views for illustrating S712 and S713 in FIG. 9 in detail.
FIG. 11 is a view for illustrating S714 to S717 in FIG. 9 in detail.
FIG. 12 is a view for illustrating S718 in FIG. 9 in detail.
FIG. 13 is a view for illustrating S720 in FIG. 7 in detail.
FIG. 14 is a flowchart for illustrating S720 in FIG. 7 in detail.
FIG. 15 is a flowchart for illustrating S730 in FIG. 7 in detail.
FIG. 16 is a view for illustrating S734 in FIG. 15 in detail.
FIG. 17 is a view for illustrating S740 in FIG. 7 in detail.
FIG. 18 is a flowchart for illustrating S740 in FIG. 7 in detail.
FIG. 19 is a view for illustrating S750 in FIG. 7 in detail.
FIG. 20 is a flowchart for illustrating S750 in FIG. 7 in detail.
FIG. 21 is a view for illustrating S760 in FIG. 7 in detail.

### DETAILED DESCRIPTION

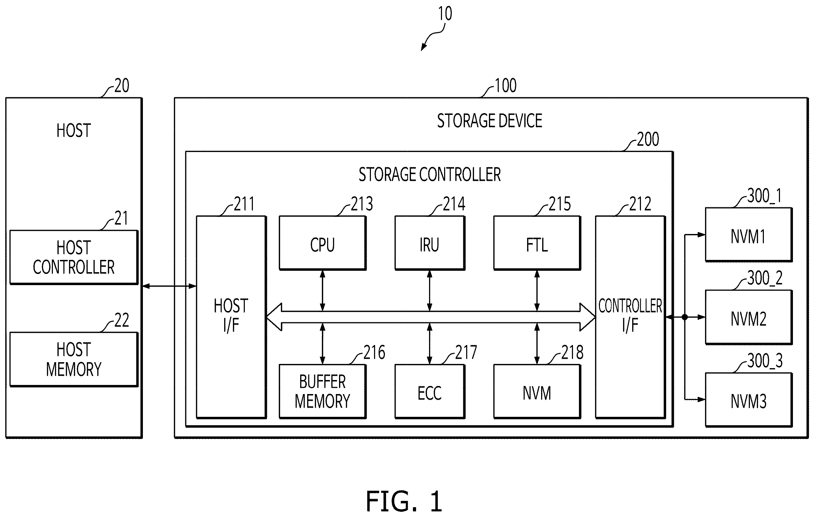

Hereinafter, various embodiments of the present disclosure will be described with reference to FIGS. 1 to 21. The same reference numerals may refer to the same components throughout this specification.

In the present disclosure, a "fast program" or "fast program operation" may refer to a program operation performed through one program loop for a single level cell or a page or word line including a single level cell. For example, a fast program operation including one program loop may be carried out on a page containing a single level cell, thereby completing a program operation for that page. The single program loop may include an operation of applying a program voltage to a single level cell or a page or word line including a single level cell, and a verification procedure (e.g., an operation of applying a verification voltage to a memory cell) may be skipped for the single program loop.

In the present disclosure, a "normal program" or "normal program operation" may refer to a program operation performed through one or more program loops including an operation of applying a program voltage to a memory cell and an operation of applying a verification voltage.

FIG. 1 shows a storage system 10 according to one embodiment of the present disclosure. Referring to FIG. 1, the storage system 10 may include a host device 20 and a storage device 100. The host device 20 and the storage device 100 may exchange data and/or signals with each other. The storage device 100 may be a non-volatile memory. The storage device may comprise one or more of an electrically programmable ROM (EPROM), an electrically erasable and programmable ROM (EEPROM), a flash memory device, a phase-change RAM (PRAM), a magnetic RAM (MRAM), and a resistive RAM (RRAM).

The host device 20 may be a device that runs an operating system (OS), such as Windows, iOS, and Android. In some embodiments, the host device 20 may include a host controller 21 and a host memory 22. The host memory 22 may serve as a buffer memory for temporarily storing data to be transmitted to the storage device 100 or data transmitted from the storage device 100.

According to one embodiment, the host controller 21 and the host memory 22 may be implemented as separate semiconductor chips. In other embodiments, the host controller 21 and the host memory 22 may be integrated into a single semiconductor chip. For example, the host controller 21 may be one of a plurality of modules of an application processor, and the application processor may be implemented as a system on chip (SoC). In addition, the host memory 22 may be an embedded memory inside the application processor, or a volatile memory or memory module placed outside the application processor.

In one embodiment, the host controller 21 may manage an operation (e.g., a write operation) of storing data of the host memory 22 in a nonvolatile memory device 300_1 to 300_3 through a storage controller 200 or an operation (e.g., a read operation) of storing data of the nonvolatile memory device 300_1 to 300_3, e.g., information on memory blocks within the nonvolatile memory device 300_1 to 300_3, in the host memory 22 through the storage controller 200.

The storage device 100 may include the storage controller 200 and a plurality of nonvolatile memory devices (NVMs) 300_1 to 300_3. Each of the storage controller 200 and the plurality of nonvolatile memory devices 300_1 to 300_3 may exchange data, signals, etc., with each other. Although three nonvolatile memory devices 300_1 to 300_3 have been illustrated in FIG. 1, the present disclosure is not limited thereto, and the storage device 100 may include any number of memory devices. For example, the storage device 100 may include a plurality of memory devices arranged and connected to each other in the form of an array.

The storage device 100 may include a storage medium for storing data at a request from the host device 20. For example, the storage device 100 may include at least one of a solid state drive (SSD), an embedded memory, and a removable external memory. When the storage device 100 is an SSD, it may be a device that follows the non-volatile memory express (NVMe) standard. When the storage device 100 is an embedded memory or an external memory, it may be a device that follows the universal flash storage (UFS) or embedded multi-media card (eMMC) standard. The host device 20 and the storage device 100 may each generate and transmit packets according to an adopted standard protocol.

When the nonvolatile memory device 300_1 to 300_3 includes a flash memory, the flash memory may include a 2D NAND memory array or a 3D, vertical, or bonding vertical NAND (VNAND) memory array. For another example, the storage device 100 may include various other types of non-volatile memory and/or volatile memory. For example, the storage device 100 may include at least one of volatile or non-volatile memories, such as static RAM (SRAM), dynamic RAM (DRAM), synchronous DRAM (SDRAM), read only memory (ROM), programmable ROM (PROM), electrically programmable ROM (EPROM), electrically erasable and programmable ROM (EEPROM), magnetic RAM (MRAM), spin-transfer torque MRAM, conductive bridging RAM (CBRAM), ferroelectric RAM (FeRAM), phase RAM (PRAM), and resistive RAM.

The storage controller 200 may include a host interface 211, a controller interface circuit 212, and a central processing unit (CPU) 213. In addition, the storage controller 200 may further include an index read unit (IRU) 214, a flash translation layer (FTL) 215, a buffer memory 216, an error correction code (ECC) engine 217, and an internal non-volatile memory 218. The storage controller 200 may further include a working memory into which the flash translation layer 215 is loaded, and the operations of writing data to and reading data from a non-volatile memory may be controlled by the CPU 213 operating the flash translation layer 215.

The host interface 211 may exchange packets with the host device 20. A packet transmitted from the host device 20 to the host interface 211 may include a command and/or data, e.g., the number of fast programs, to be written to or transmitted to the nonvolatile memory device 300_1 to 300_3, and a packet transmitted from the host interface 211 to the host device 20 may include a response to a command, data read from the nonvolatile memory device 300_1 to 300_3, or information on a memory block, e.g., a cell count value in the range of a specific threshold voltage. The drawing shows the host interface 211 placed inside the storage controller 200, but the present disclosure is not limited thereto. For example, the host interface 211 may be arranged outside the storage controller 200.

The controller interface circuit 212 may transmit data to be written in the nonvolatile memory device 300_1 to 300_3 to the nonvolatile memory device 300_1 to 300_3 or receive data read from the nonvolatile memory device 300_1 to 300_3. Such a controller interface circuit 212 may be designed to comply with a standard protocol such as toggle or Open NAND Flash Interface (ONFI).

The flash translation layer 215 may perform various functions such as address mapping, wear-leveling, and garbage collection. In addition, the buffer memory 216 may temporarily store data to be written to the memory device 300_1 to 300_3 or data read from the nonvolatile memory device 300_1 to 300_3. The buffer memory 216 may be a component placed within the storage controller 200, but can also be positioned outside the storage controller 200.

The ECC engine 217 may serve to detect and correct errors in read data read from the nonvolatile memory device 300_1 to 300_3. More specifically, the ECC engine 217 may generate a parity bit for written data to be written to the nonvolatile memory device 300_1 to 300_3, and the parity bit generated in such a manner may be stored in the nonvolatile memory device 300_1 to 300_3 together with the written data. When reading data from the nonvolatile memory device 300_1 to 300_3, the ECC engine 217 may correct errors in the read data using a parity bit read from the nonvolatile memory device 300_1 to 300_3 as well as the read data and output the read data with the errors corrected.

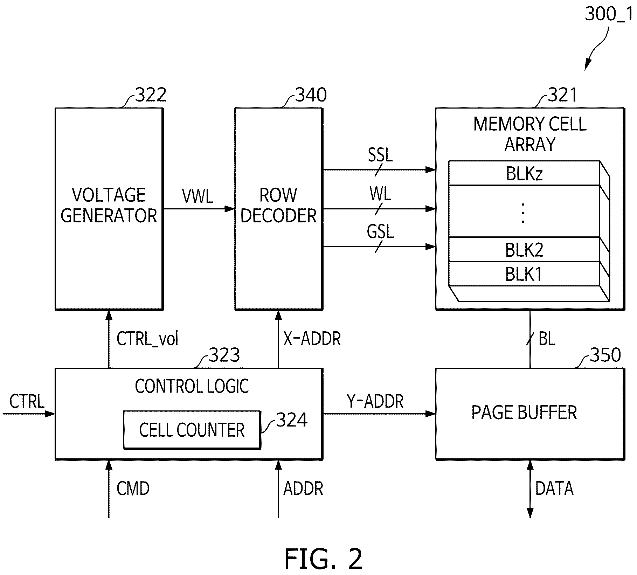

FIG. 2 is a view for illustrating a nonvolatile memory according to one embodiment of the present disclosure. With reference to FIG. 2, components of the nonvolatile memory device 300_1 in FIG. 1 will be described, but it should be understood that the embodiments described with reference to FIG. 2 can be applied to any nonvolatile memory device connected to the storage controller 200 in FIG. 1.

Referring to FIG. 2, the nonvolatile memory device 300_1 may include a memory cell array 321, a voltage generator 322, a control logic circuit 323, a row decoder 340, and a page buffer circuit 350. In other embodiments, the nonvolatile memory device 300_1 may further include a data input/output circuit or an input/output interface.

The memory cell array 321 may include a plurality of memory cells and be connected to word lines WL, string selection lines SSL, ground selection lines GSL, and a plurality of bit lines BL. Specifically, the memory cell array 321 may be connected to the row decoder 340 through the word lines WL, the string selection lines SSL, and the ground selection lines GSL and may be connected to the page buffer circuit 350 through the plurality of bit lines BL.

The memory cell array 321 may include a plurality of memory blocks BLK1 to BLKz. Each of the plurality of memory blocks BLK1 to BLKz may include a plurality of pages to which memory cells are connected. One or more pages may be connected to each of the word lines WL.

Each of the plurality of memory blocks BLK1 to BLKz may have a three-dimensional or vertical structure. Specifically, each memory block may include structures extending in first to third directions. For example, each memory block may include a plurality of NAND strings extending in the third direction. Here, the plurality of NAND strings may be spaced apart from each other by a specific distance in the first and second directions.

The row decoder 340 may select one of the plurality of memory blocks BLK1 to BLKz. For example, the row decoder 340 may select a memory block corresponding to a block address among the plurality of memory blocks BLK1 to BLKz.

Each of the memory cells of the memory cell array 321 may store at least one bit. In one embodiment, the memory cell may be a single level cell (SLC) that stores 1 bit of data. In one embodiment, the memory cell may be a multi-level cell (MLC) or double level cell that stores 2 bits of data, a triple level cell (TLC) that stores 3 bits of data, a quadruple level cell (QLC) that stores 4 bits of data, etc. That is, the memory cell may be an MLC that stores 2 or more bits of data, but the present disclosure is not limited thereto. In this context, MLC may refer to a cell that stores 2 or more bits of data (e.g., in contrast to an SLC).

The plurality of memory blocks BLK1 to BLKz may include at least one of a single-level cell block containing SLCs, a double level block containing double level cells, a triple-level cell block containing TLCs, a quad-level cell block containing QLCs, and a multi-level cell block containing MLCs,. For example, some of the plurality of memory blocks BLK1 to BLKz of the memory cell array 321 may be single-level cell blocks, and the others thereof may be multi-level cell blocks (e.g., double-level cell blocks or triple-level cell blocks).

When an erasing voltage is applied to the memory cell array 321, the plurality of memory cells may be in an erasing state (otherwise known as an erased state), and, when a program voltage is applied to the memory cell array 321, the plurality of memory cells may be in a program state (otherwise known as a programmed state). Here, each memory cell may be in an erasing state or at least one program state distinguished according to one or more threshold voltages. That is, the states of the memory cell may include an erasing state and at least one program state, and a specific state of each memory cell may be one of an erasing state and at least one program state.

The control logic circuit 323 may control various operations performed in the nonvolatile memory device 300_1. For example, the control logic circuit 323 may output various control signals for writing data to the memory cell array 321 or reading data from the memory cell array 321 based on a command CMD, an address ADDR, and a control signal CTRL. The control logic circuit 323 may control multiple program operations to be performed for multiple pages.

The various control signals output by the control logic circuit 323 may be sent to the voltage generator 322, the row decoder 340, and the page buffer circuit 350. For example, the control logic circuit 323 may provide a voltage control signal CTRL_vol to the voltage generator 322.

In some embodiments, the control logic circuit 323 may further include a cell counter 324. The cell counter 324 may count the number of memory cells corresponding to a specific threshold voltage or the range of a specific threshold voltage from data sensed by the page buffer circuit 350. The cell counter 324 may generate a cell count value indicating the number of memory cells. The number of memory cells corresponding to the range of a specific threshold voltage may be counted through two reading operations each corresponding to a threshold voltage corresponding to a boundary value of the range of the threshold voltage or a single precharge double sensing (SPDS) operation, but the present disclosure is not limited thereto.

The voltage generator 322 may be connected to the memory cell array 321 through the plurality of word lines WL. The voltage generator 322 may generate various types of voltages for performing a program operation, a reading operation, and/or an erasing operation on the memory cell array 321 based on the voltage control signal CTRL_vol. The voltage generator 322 may generate word line voltages VWL, such as a program voltage, a verifying voltage, a reading voltage, and an erasing voltage.

The program voltage, the verifying voltage, the reading voltage, the erasing voltage, etc. generated by the voltage generator 322 may be provided to a selected word line among the plurality of word lines WL. The selected word line may be at least one word line selected through a row address X-ADDR. Each of the plurality of word lines WL may include a plurality of pages, and program operations, verifying operations, reading operations, etc. carried out through the voltages generated by the voltage generator 322 may be performed on a page-by-page basis. For example, a program voltage (or pulse) and a verifying voltage (or pulse) may be applied to a selected page within a selected word line, thereby performing a program and a verifying operation on the selected page.

During an erasing operation, the voltage generator 322 may apply an erasing voltage to a well and/or common source line of the memory block. In addition, based on an erasing address, the voltage generator 322 may apply an erasing allowance voltage, e.g., a ground voltage, to all the word lines WL of the memory block or some of the word lines corresponding to some sub-blocks. During an erasing verifying operation, the voltage generator 322 may apply an erasing verifying voltage to all the word lines WL of one memory block or apply it on a word line-by-word line basis.

During a program operation, the voltage generator 322 may apply a program voltage to a selected word line among the plurality of word lines WL and apply a program pass voltage to unselected word lines among the plurality of word lines WL. In addition, during a program verification operation, the voltage generator 322 may apply a program verification voltage to a selected word line and apply a verification pass voltage to unselected word lines.

During a normal reading operation, the voltage generator 322 may apply a reading voltage to a selected word line and apply a reading pass voltage to unselected word lines.

During a data recovery reading operation, the voltage generator 322 may apply a reading pass voltage to a selected word line and apply a reading voltage to at least one word line adjacent to the selected word line. Alternatively, the voltage generator 322 may apply a reading voltage to a selected word line and to at least one word line adjacent to the selected word line.

The row decoder 340 may select a specific one from the word lines WL in response to the row address X-ADDR received from the control logic circuit 323. Specifically, during a program operation, the row decoder 340 may provide a program voltage to a selected word line. In addition, the row decoder 340 may select some of the string selection lines SSL or some of the ground selection lines GSL in response to the row address X-ADDR received from the control logic circuit 323.

The page buffer circuit 350 may be connected to the memory cell array 321 through the plurality of bit lines BL. The page buffer circuit 350 may select some of the plurality of bit lines BL in response to a column address Y-ADDR received from the control logic circuit 323. During a verifying operation, such as an erasing verifying operation or a program verifying operation, or a reading operation, the page buffer circuit 350 may operate as a sensing amplifier to sense data stored in a selected memory cell through a selected bit line. Meanwhile, during a program operation, the page buffer circuit 350 may operate as a writing driver to input data to be stored in the memory cell array 321. The page buffer circuit 350 may include a plurality of page buffers. In this case, each of the page buffers may be connected to at least one bit line.

The page buffer circuit 350 may store data read from the memory cell array 321 or data to be stored in the memory cell array 321.

The page buffer circuit 350 may include a plurality of page buffers connected to their respective bit lines BL. The plurality of page buffers may be arranged to correspond to their respective bit lines, and each page buffer may include a plurality of latches. Hereinafter, the page buffer circuit 350 will be defined as a page buffer circuit including the plurality of page buffers connected to their respective bit lines. However, terms used to describe the embodiments of the present disclosure may be defined differently, and, for example, one single page buffer may be disposed corresponding to a number of bit lines, and a unit of components arranged corresponding to each bit line may be defined as a page buffer unit. The page buffer circuit 350 may temporarily store data to be programmed in a selected page during a program operation and temporarily store data read from a selected page during a reading operation.

The control logic circuit 323, the voltage generator 322, the row decoder 340, and the page buffer circuit 350 may form a peripheral circuit.

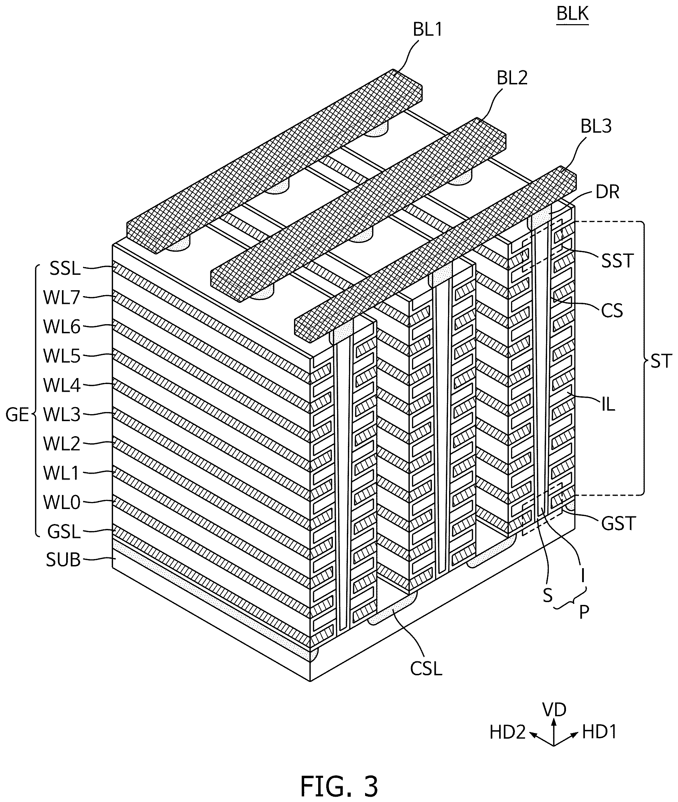

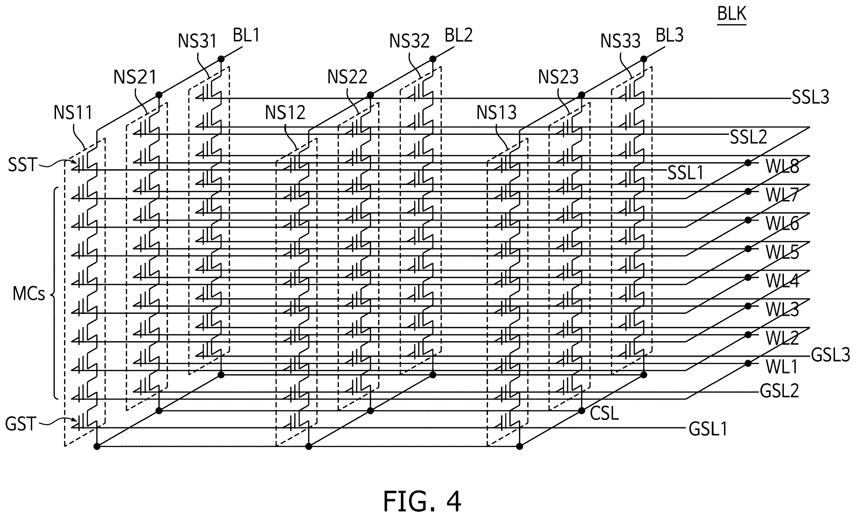

FIG. 3 is a perspective view of a memory block according to one embodiment of the present disclosure, and FIG. 4 is a circuit diagram of the memory block according to one embodiment of the present disclosure.

Referring to FIG. 3, a memory block BLK may include a stack ST extending in a vertical direction VD on a substrate SUB. For example, the memory block BLK may include a single stack ST between the substrate SUB and bit lines BL1 to BL3. A common source line CSL may be arranged on the substrate SUB, and insulating films IL extending in a second horizontal direction HD2 may be sequentially disposed in the vertical direction VD in an area between two common source lines CSL adjacent to each other on the substrate SUB. The insulating films IL may be spaced apart from each other by a certain distance in the vertical direction VD. In the areas between two common source lines CSL adjacent to each other on the substrate SUB, pillars P penetrating the insulating films IL in the vertical direction VD may be arranged. The pillars may be referred to as channel holes. The pillars P may be in the shape of a cup or a cylinder with a closed bottom surface extending in the vertical direction VD. A surface layer S of each of the pillars P may contain a first type of silicon material and may serve as a channel region. Meanwhile, an inner layer I of each of the pillars P may contain an insulating material such as silicon oxide or an air gap.

In the area between two common source lines CSL adjacent to each other, a charge storage layer CS may be arranged along the exposed surfaces of the insulating films IL, the pillars P, and the substrate SUB. The charge storage layer CS may include a gate insulating layer, a charge trap layer, and a blocking insulating layer. For example, the charge storage layer CS may have an oxide-nitride-oxide (ONO) structure. In addition, gate electrodes GE, such as the selection lines GSL and SSL and word lines WL1 to WL8, may be arranged on the exposed surface of the charge storage layer CS in the area between two common source lines CSL adjacent to each other. A drain DR may be disposed on each of the plurality of pillars P. On the drains DR, the bit lines BL1 to BL3 extending in a first horizontal direction HD1 and spaced apart from each other by a specific distance in the second horizontal direction HD2 may be arranged.

Referring to FIG. 4, the memory block BLK may include NAND strings NS11 to NS33, and each NAND string, e.g., NS11, may include a string selection transistor SST, a plurality of memory cells MCs, and a ground selection transistor GST, connected in series. The transistors SST and GST and the memory cells MCs of each NAND string may be stacked vertically on the substrate.

The bit lines BL1 to BL3 may extend in a first direction, and the word lines WL1 to WL8 may extend in a second direction. The NAND strings NS11, NS21, and NS31 may be positioned between the first bit line BL1 and the common source line CSL, the NAND strings NS12, NS22, and NS32 may be positioned between the second bit line BL2 and the common source line CSL, and the NAND strings NS13, NS23, and NS33 may be positioned between the third bit line BL3 and the common source line CSL.

The string selection transistor SST may be connected to a corresponding string selection line SSL1 to SSL3. The memory cells MCs may be connected to their respective word lines WL1 to WL8. The ground selection transistor GST may be connected to a corresponding ground selection line GSL1 to GSL3. The string selection transistor SST may be connected to a corresponding bit line, and the ground selection transistor GST may be connected to the common source line CSL. Here, the numbers of the NAND strings, the word lines, the bit lines, the ground selection lines, and the string selection lines may vary depending on embodiments.

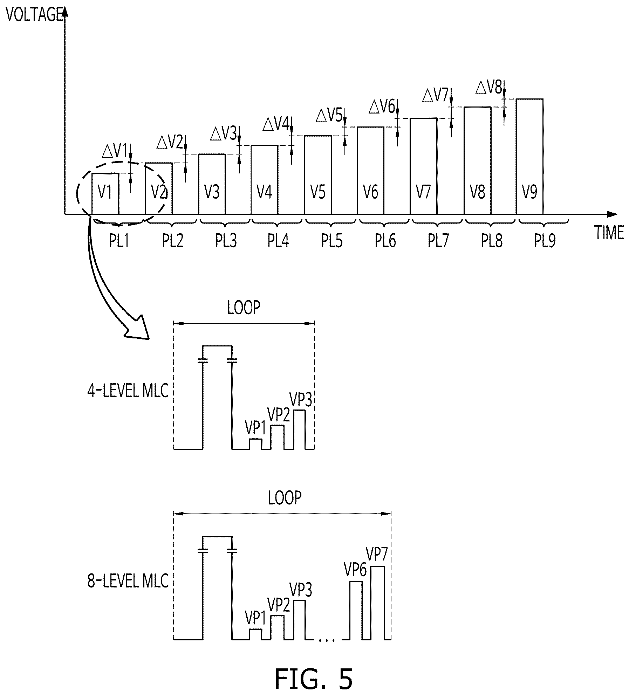

FIG. 5 shows a series of program voltages for programming memory cells with multi-level data according to one embodiment of the present disclosure.

As for how to perform the programming, as illustrated in FIG. 5, the program voltage may be applied to a control gate of a storage element such as a memory cell as a series of program voltages V1 to V9. The memory device may program data into memory cells by performing a plurality of program loops PL1 to PL9 on the memory cells. This is an example, and the number of the program voltages V1 to V9 may vary.

The level of the program voltages V1 to V9 may increase with each successive voltage by a predetermined level of step △V1 to △V8. In the sections between the program voltages V1 to V9, verification operations may be carried out.

For a memory array including multi-level cells, verification operations may be performed for each program state of a storage element to determine whether the storage element has reached its verification level associated with data. For example, multi-level cells, e.g., a 4-level MLC, that can store data in four program states may require verification operations in connection with three comparing pointers or verification voltages VP1 to VP3. Similarly, multi-level cells, e.g., an 8-level MLC, that can store data in eight program states may carry out verification operations in connection with seven comparing pointers or verification voltages VP1 to VP7. Generally, memory cells that store data in n program states may carry out verification operations in connection with n-1 comparing pointers or verification voltages.

The program voltages V1 to V9 in FIG. 5 are illustrated with reference to the Incremental Step Pulse Programming (ISPP) program, and the voltage application time (the horizontal width of the graph) may be constant. The program loop in FIG. 5 may increase an application voltage value of each voltage by a predetermined level of step, i.e., △V1 to △V8, to control threshold voltages of memory cells. While nine programming voltages are shown in FIG. 5, other numbers of programming voltages may be applied.

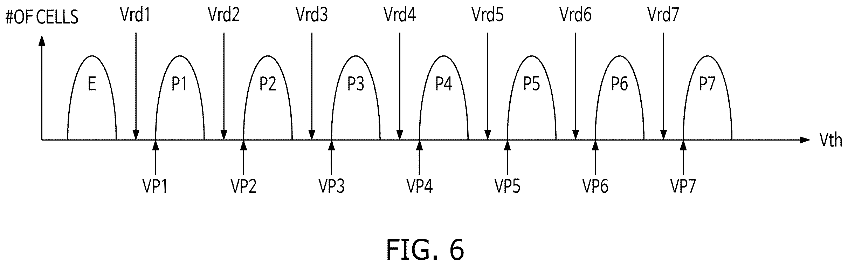

FIG. 6 is a view for illustrating states of a plurality of memory cells according to some embodiments of the present disclosure.

States of a TLC E and P1 to P7 have been illustrated in FIG. 6, and the embodiment illustrated in FIG. 6 is based on the TLC, but the embodiments of the present disclosure are not limited thereto. For example, the embodiments of the present disclosure described below can be applied to an SLC that may have two states, e.g., E and P1, a dual level cell that may have four states, e.g., E and P1 to P3, a QLC that may have 16 states, e.g., E and P1 to P15, etc. The following embodiments will be described assuming that a memory cell is a TLC. The number of states may be 2**^{b}** where b is the number of bits that can be stored in the call.

In Fig. 6, the horizontal axis represents threshold voltages (Vth) of memory cells, and the vertical axis represents the number of memory cells (# of cells) corresponding to the threshold voltages (Vth) or a memory cell counting value.

A TLC may have any one of eight states E and P1 to P7. For example, an erased TLC may have an erasing state E. For another example, a programmed TLC may have any one of seven program states P1 to P7.

Through programming a TLC, the area of threshold voltage distribution corresponding to at least one state of the TLC may be different from the areas of threshold voltage distributions corresponding to other states. For example, through programming the TLC, the areas of threshold voltage distributions corresponding to some states E and P1 to P5 of the TLC may be identical to each other, the area of threshold voltage distribution of a sixth program state may be larger than the areas of the threshold voltage distributions corresponding to the states E and P1 to P5 of the TLC, and the area of threshold voltage distribution of a seventh program state P7 may be smaller than the areas of the threshold voltage distributions corresponding to the states E and P1 to P5 of the TLC.

Hereinafter, the area of a specific threshold voltage range within a threshold voltage distribution corresponding to a specific state and the number of memory cells within the threshold voltage range may refer to the same object, so the two expressions may be used interchangeably.

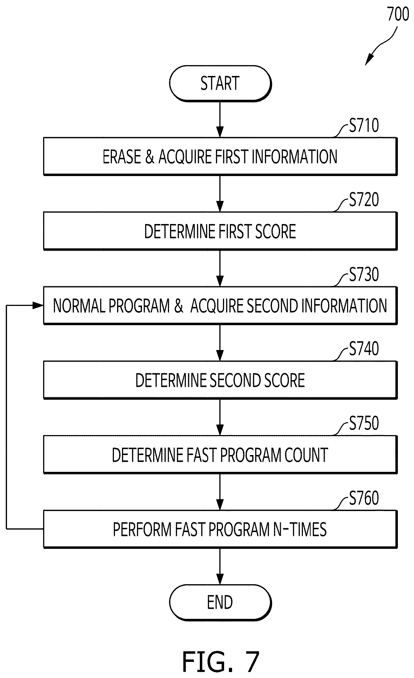

During a reading operation, the state of the TLC (E and P1 to P7) may be determined by sequentially applying first to seventh reading voltages Vrd1 to Vrd7 to an unselected word line and first to seventh verification voltages VP1 to VP7 to a selected word line. However, because, during a program operation, the verification voltages VP1 to VP7 may be applied to the selected word lines in addition to a program voltage Vpgm, e.g., one of V1 to V9 in FIG. 5, it takes a lot of time to perform the program operation. As in the case of the TLC described above, during a program operation on an SLC, a verification operation for applying a verification voltage to the SLC takes time. Accordingly, various embodiments in which the time required for a program operation is shortened by skipping at least part of a verification procedure of the program operation while ensuring the reliability of the program operation will be described below with reference to FIGS. 7 to 21.

FIG. 7 shows an operating method 700 of a storage system according to one embodiment of the present disclosure. The operating method 700 of the storage system may be performed by a storage system, e.g., the storage system 10 in FIG. 1, and may be carried out for a specific memory block within a memory cell array of a memory device. The operating method 700 of the storage system may be an operating method for reducing time and resources required for performing a program operation in a memory block by carrying out a fast program operation on at least some of a plurality of pages in the memory block. For example, one single program loop may be performed without a verification procedure for a page or word line containing a single-level cell, so that the time and resources required to apply a verification voltage to a memory cell may be reduced.

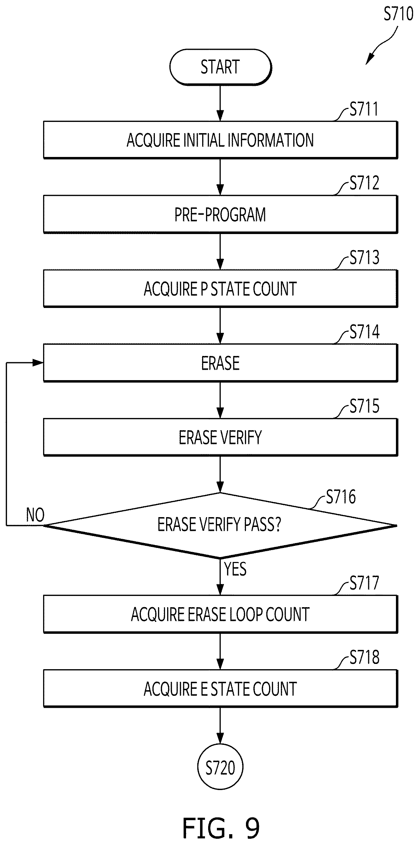

The storage system or the control logic circuit of the memory device may perform an erasing operation on a memory block and obtain first information on the memory block based on the erasing operation at S710. The specific process of S710 will be described in detail with reference to FIGS. 9 to 12.

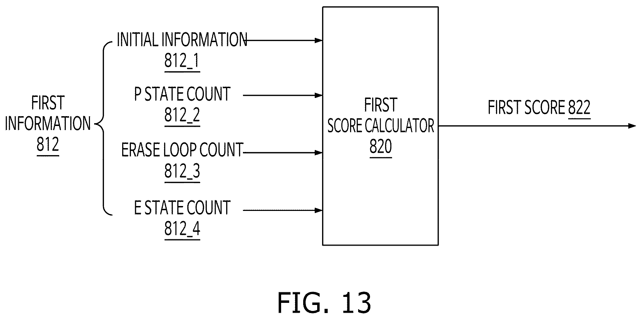

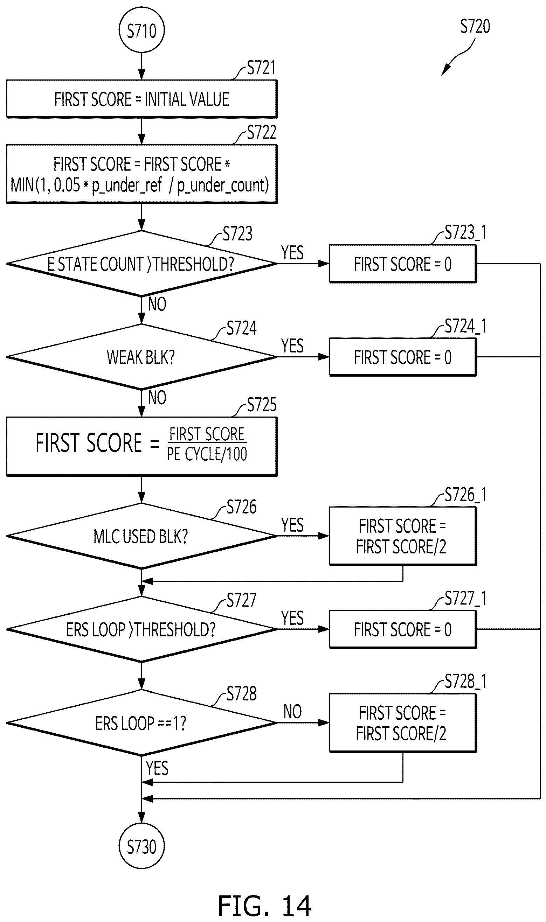

The storage system may determine a first score based on the first information obtained at S710 at S720. The specific process of S720 will be described in detail with reference to FIGS. 13 and 14.

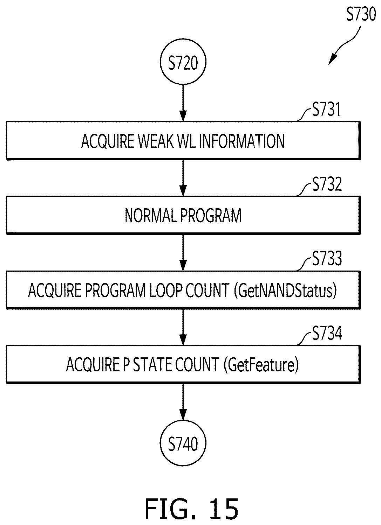

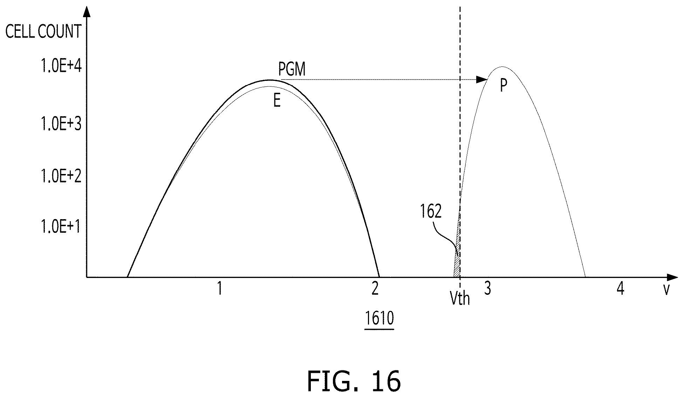

The storage system or the control logic circuit of the memory device may perform a normal program operation of executing one or more program loops and obtain a second information on the memory block based on the normal program operation at S730. The specific process of S730 will be described in detail with reference to FIGS. 15 and 16.

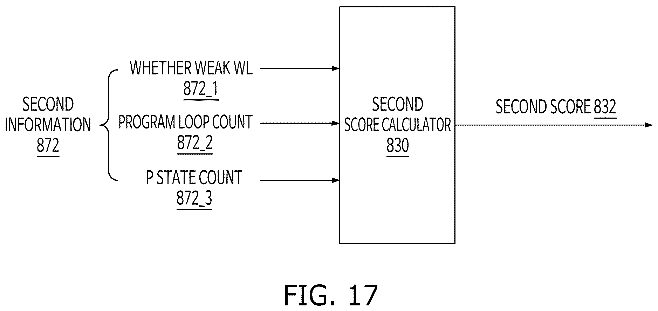

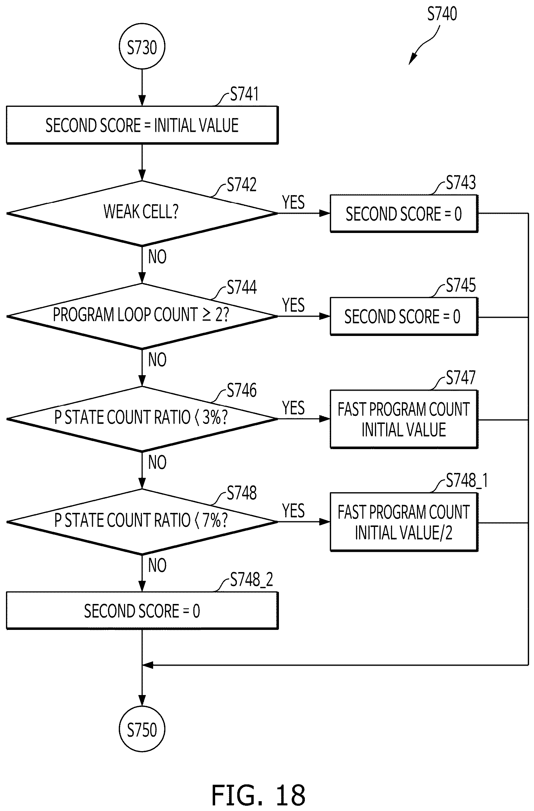

The storage system may determine a second score based on the second information obtained in S730 in S740. The specific process of S740 will be described in detail with reference to FIGS. 17 and 18.

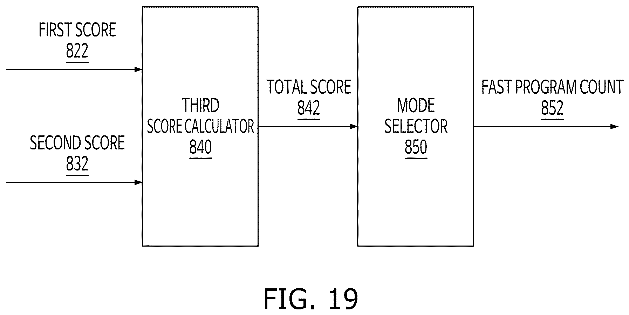

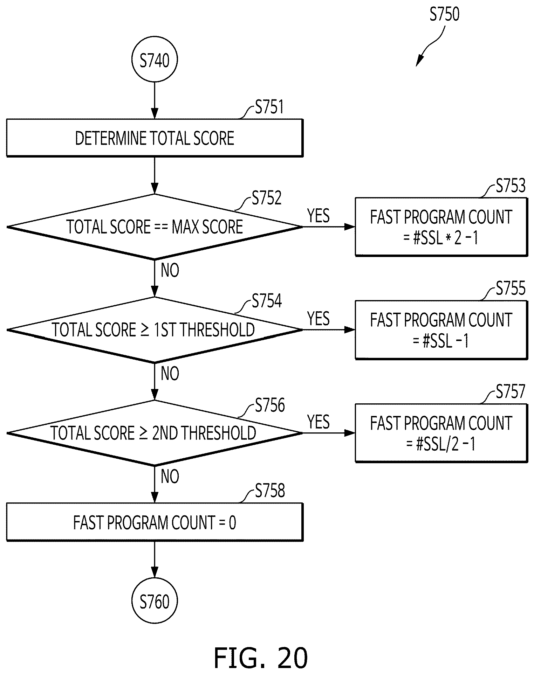

At S750, the storage system may determine the number of word lines or pages to which a fast program operation will be applied based on the first score and the second score determined in S720 and S740, respectively. The specific process of S750 will be described in detail with reference to FIGS. 19 and 20.

At S760, the storage system or the control logic circuit of the memory device may perform a fast program operation based on a fast program count, which has been determined at S750. For example, the storage system may determine that the fast program count is N times (N is an integer equal to or greater than zero), and may carry out the fast program operation for N pages.

In one embodiment, the storage controller may transmit, to the memory device, a command for commanding a program operation to skip a verification procedure for each of pages corresponding to the fast program count, which has been determined, and the memory device may perform a fast program operation for the pages corresponding to the fast program count in response to the receipt of the command. The command for commanding the program operation to skip the verification procedure may include a single command, or may include a program command for the program operation and a command for the skipping of the verification.

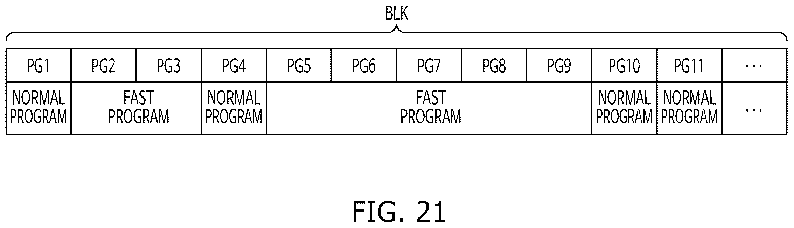

In other embodiments, the storage controller may transmit a program command for a program operation to the memory device, and the memory device may determine a fast program count and carry out a fast program operation for pages that the program command commands and correspond to the fast program count, which has been determined. The specific process of S760 will be described in detail with reference to FIG. 21.

In response to fully performing the fast program operation at S760 the number of times corresponding to the fast program count determined at S750, the storage system may carry out a normal program operation by applying a program voltage and a verification voltage to a page on which a program operation is to be performed following a page on which a fast program operation has been performed and may obtain the second information at S730. The storage system may determine or update the second score based on the obtained second information, e.g., information on the page on which the normal program has been performed, at S740, and may determine or update, based on the determined second score, the count of fast programs to be performed following the page on which the normal program operation has been carried out at S750. As a result, a fast program count may be determined by taking into account information on adjacent pages or word lines.

In one embodiment, the storage system may update the fast program count only when the fast program count decreases (e.g., only when the updated fast program count is less than the previous fast program count).

The storage system may perform a fast program operation by applying a program voltage and skipping a verification procedure for each page corresponding to the updated fast program count at S760.

The storage system may repeat S730 to S760 until the normal program operation or the fast program operation is completed for all pages within the memory block. That is, the storage system may repeat S730 to S760 until all pages within the memory block have been programmed.

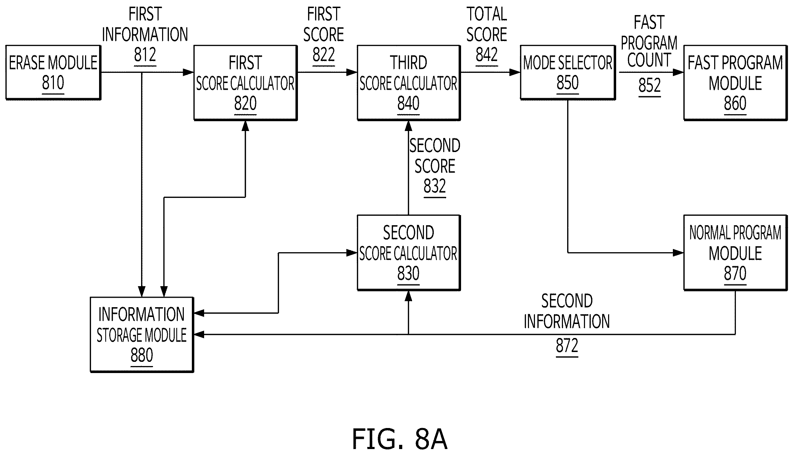

FIG. 8A shows components of a storage system that performs the operating method of the storage system in FIG. 7.

An erase module 810 may perform an erasing operation on a memory block, e.g., the erasing operation of S710 in FIG. 7. The erase module 810 may obtain a first information 812, e.g., the first information of S710 in FIG. 7, on the memory block based on the result of performing the erasing operation, etc., and transmit the obtained first information 812 to a first score calculator 820. The information storage module 880 may store the first information 812. The erase module 810 may transmit the obtained first information 812 to an information storage module 880.

The first score calculator 820 may determine a first score 822, e.g., the first score of S720 in FIG. 7, based on the received first information 812 and transmit the determined first score 822 to a third score calculator 840. The first score calculator 820 may transmit the determined first score 822 to the information storage module 880. The information storage module 880 may store the first score 822.

A normal program module 870 may perform a normal program operation, e.g., the normal program operation of S730 in FIG. 7, for a specific page, e.g., a selected page, within a memory block. The normal program module 870 may obtain a second information 872, e.g., the second information of S730 in FIG. 7, on a selected page and/or a selected word line including the selected page based on the result of performing a normal program operation, etc., and transmit the obtained second information 872 to a second score calculator 830. The normal program module 870 may transmit the obtained second information 872 to the information storage module 880. The information storage module 880 may store the second information 872.

The second score calculator 830 may determine a second score 832, e.g., the second score of S740 in FIG. 7, based on the received second information 872 and transmit the determined second score 832 to the third score calculator 840. The second score calculator 830 may transmit the determined second score 832 to the information storage module 880. The information storage module 880 may store the second score 832.

The third score calculator 840 may determine a total score 842 (e.g., a third score) based on the first score 822 and the second score 832, which have been received, and transmit the determined total score 842 to a mode selector 850. Although not shown in FIG. 8A, the third score calculator 840 may transmit the determined total score 842 to the information storage module 880. The information storage module 880 may store the total score 842.

The mode selector 850 may receive the total score 842, and may determine a fast program count 852 and transmit it to a fast program module 860 based on the received total score 842. For example, when the fast program count 852 is greater than or equal to one, the mode selector 850 may transmit the fast program count 852 to the fast program module 860 together with a command or signal to activate the fast program module 860.

When a fast program operation has been performed the number of times corresponding to the fast program count 852 or the fast program count 852 is 0, the mode selector 850 may transmit a command or signal to activate the normal program module 870 to the normal program module 870. For example, the mode selector 850 may count the number of times the fast program operation has been performed through a program counter, etc. whenever it transmits a command or signal to activate the fast program module to the fast program module 860, and may transmit a command or signal to activate the normal program module 870 to the normal program module 870 when the number of times the fast program operation has been performed is equal to the fast program count 852.

Referring to FIG. 8A, the third score calculator 840 and the mode selector 850 are separate components, but the present disclosure is not limited thereto. For example, the third score calculator 840 and the mode selector 850 may be formed as one module, and the single module may receive the first score 822 and the second score 832 and output the fast program count 852.

In FIG. 8A, the calculators 820, 830, and 840 are separate components, but the present disclosure is not limited thereto. The first score calculator 820 and the second score calculator 830 may be formed as one single calculator, or the first score calculator 820, the second score calculator 830, and the third score calculator 840 may be formed as one single calculator.

The fast program module 860 and the normal program module 870 may be formed as one single program module.

In one embodiment, the first score calculator 820, the second score calculator 830, the third score calculator 840, the mode selector 850, etc. may include or be connected to corresponding memories, e.g., registers. For example, after the first score 822 determined from the first score calculator 820 and the second score 832 determined from the second score calculator 830 have been stored in a register included in or connected to the third score calculator 840, the third score calculator 840 may begin to calculate the total score 842 by performing a reading operation on its corresponding register.

Information stored in the information storage module 880 may be stored for a predetermined time, a predetermined fast program count, and a predetermined number of times the fast program count is calculated. The information stored in the information storage module 880 may be used by the calculator 820, 830, and 840. For example, for data collected immediately after a sudden power off (SPO) of a memory device, the total score 842 may be calculated by reflecting the data used when calculating the previous total score at a certain ratio.

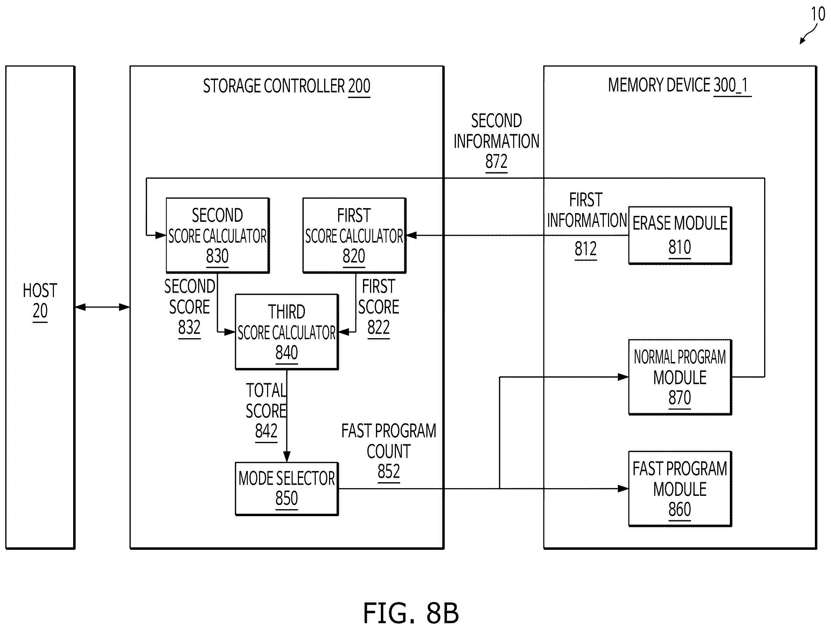

FIGS. 8B to 8D show various examples of the positions of the components in FIG. 8A on the storage system 10.

Referring to FIGS. 8B to 8D, the erase module 810, the fast program module 860, and the normal program module 870 may be included in the memory device 300_1. For example, the erase module 810, the fast program module 860, and the normal program module 870 may be included in a control logic circuit, e.g., the control logic circuit 323 in FIG. 2, of the memory device 300_1. It should be understood that the components of the memory device 300_1 in FIGS. 8B to 8D can be applied to any memory device connected to the storage controller 200.

Referring to FIG. 8B, the first score calculator 820, the second score calculator 830, the third score calculator 840, and the mode selector 850 may be included in the storage controller 200.

According to the embodiment illustrated in FIG. 8B, the memory device 300_1 or the control logic circuit may perform an erasing operation on a memory block. The memory device 300_1 or the control logic circuit may obtain the first information 812 on the memory block based on the result of performing the erasing operation, etc., and transmit the obtained first information 812 to the storage controller 200.

The memory device 300_1 or the control logic circuit may perform a normal program operation for a specific page within the memory block. The memory device 300_1 or the control logic circuit may obtain the second information 872 on a selected page and/or a selected word line including the selected page based on the result of performing the normal program operation, etc., and transmit the obtained second information 872 to the storage controller 200.

The storage controller 200 may receive the first information 812 and the second information 872 on the memory block.

The storage controller 200 may determine a fast program count based on the information on the memory block and transmit it to the memory device 300_1. For example, the storage controller 200 may determine the first score 822 based on the received first information 812 and the second score 832 based on the received second information 872. The storage controller 200 may determine the total score 842 based on the first score 822 and the second score 832, and may determine the fast program count 852 for performing a fast program operation based on the total score 842 and transmit it to the memory device 300_1.

When the fast program count 852 is greater than or equal to one, the storage controller 200 may transmit the fast program count 852 to the fast program module 860 or the control logic circuit together with a command or signal for activating the fast program module 860. On the other hand, when the fast program count 852 is zero, the storage controller 200 may transmit a command or signal to activate the normal program module 870 to the normal program module 870 or the control logic circuit.

The memory device or control logic circuit may receive information on the fast program count 852 from the storage controller 200 and perform a fast program operation by applying a program voltage to and skipping a verification procedure for each page corresponding to the fast program count 852. The memory device or control logic circuit may carry out a normal program operation by applying a program voltage and a verification voltage to a page on which a program operation is to be performed following the pages corresponding to the fast program count 852.

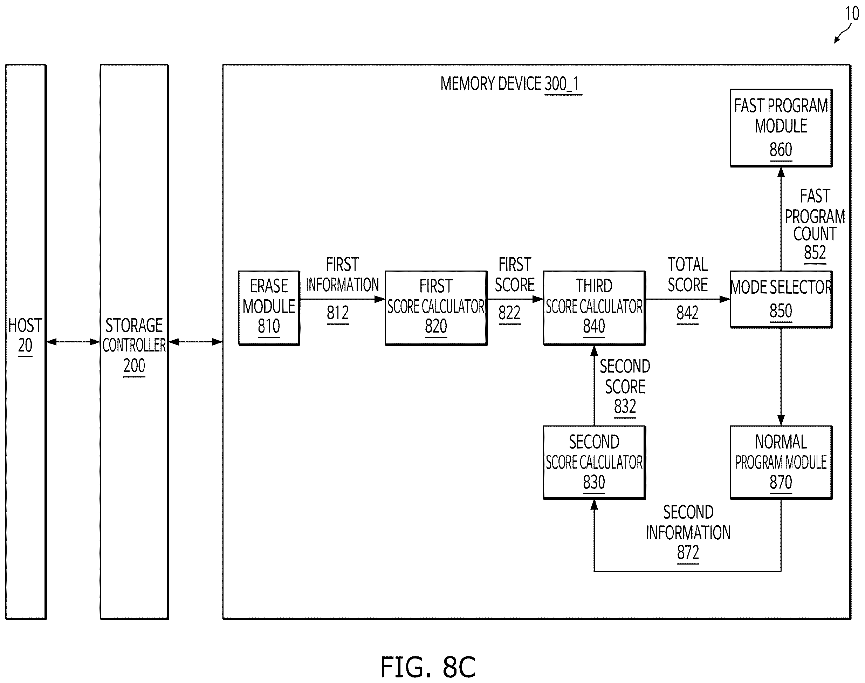

Referring to FIG. 8C, the first score calculator 820, the second score calculator 830, the third score calculator 840, and the mode selector 850 may be included in the memory device 300_1.

Unlike the example in FIG. 8B, the memory device 300_1 or the control logic circuit may determine the fast program count 852 based on the information on the memory block. For example, the memory device 300_1 or the control logic circuit may determine the first score 822 based on the first information 812 and the second score 832 based on the second information 872. The memory device 300_1 or the control logic circuit may determine the total score 842 based on the first score 822 and the second score 832, and determine the fast program count 852 for performing a fast program operation based on the total score 842.

When the fast program count 852 is greater than or equal to one, the fast program module 860 may perform a fast program operation by applying a program voltage to and skipping a verification procedure for each page corresponding to the fast program count 852. The normal program module 870 may carry out a normal program operation by applying a program voltage and a verification voltage to a page on which a program operation is to be performed following the pages corresponding to the fast program count 852.

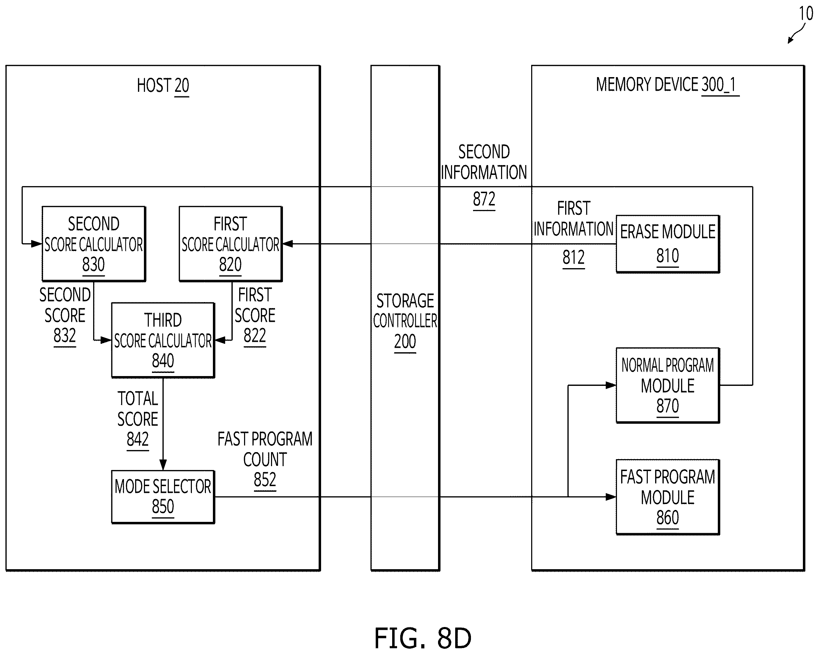

Referring to FIG. 8D, the first score calculator 820, the second score calculator 830, the third score calculator 840, and the mode selector 850 may be included in the host device 20.

Unlike the example in FIG. 8B, the memory device 300_1 or the control logic circuit may transmit the first information 812 and the second information 872, which have been obtained, to the host device 20 through the storage controller 200.

The host device 20 may receive the first information 812 and the second information 872 related to the memory block through the storage controller 200.

The host device 20 may determine a fast program count based on the information on the memory block and transmit it to the memory device 300_1 through the storage controller 200. For example, the host device 20 may determine the first score 822 based on the received first information 812 and the second score 832 based on the received second information 872. The host device 20 may determine the total score 842 based on the first score 822 and the second score 832, and determine the fast program count 852 for performing a fast program operation based on the total score 842 and transmit it to the memory device 300_1 through the storage controller 200.

When the fast program count 852 is greater than or equal to one, the host device 20 may transmit the fast program count 852 to the fast program module 860 or the control logic circuit through the storage controller 200 along with a command or signal for activating the fast program module 860. On the other hand, when the fast program count 852 is zero, the host device 20 may transmit a command or signal for activating the normal program module 870 to the normal program module 870 or the control logic circuit through the storage controller 200.

The memory device or the control logic circuit may receive the fast program count 852 from the host device 20 through the storage controller 200 and perform a fast program operation by applying a program voltage to and skipping a verification procedure for each page corresponding to the fast program count 852. The memory device or the control logic circuit may carry out a normal program operation by applying a program voltage and a verification voltage to a page on which a program operation is to be performed following the pages corresponding to the fast program count 852.

In one embodiment, the information storage module 880 in FIG. 8A may be included in the host device 20, the storage controller 200, or the memory device 300_1. In other embodiments, the information storage module 880 in FIG. 8A may include a plurality of modules, and each of the plurality of modules may be included in the host device 20, the storage controller 200, or the memory device 300_1.

FIG. 9 is a flowchart for illustrating S710 in FIG. 7 in detail. S710 may be performed by a memory device, e.g., the memory device 300_1 in FIG. 2, specifically, a control logic circuit of the memory device, e.g., the control logic circuit 323 in FIG. 2. The information obtained in S711, S713, S717 and S718 in FIG. 9 may be included in the first information on the memory block of S710 in FIG. 7.

The memory device may obtain initial information at S711. The initial information may include information that can be obtained without performing a separate erasing operation or pre-program operation. The initial information may be information related to the current performance and/or usage period of the memory block.

In one embodiment, the initial information may include whether the memory block corresponds to a weak block. The weak block may refer to a memory block in which the increase rate of an error bit is greater than a threshold increase rate during a program-erase cycle (PE cycle) of the memory block. The increase rate of an error bit may be a rate at which a bit error rate increases over multiple program-erase cycles. The bit error rate may be the raw bit error rate (e.g., the bit error rate (e.g., the number of erroneous bits) before error correction). When a memory block corresponds to the weak block, there may be a high probability that the programming of pages within the memory block will not succeed through a single program loop, i.e., a fast program operation will fail. Whether a specific memory block corresponds to the weak block may be determined by information stored in advance in the memory controller or the memory device, or by looking up the address of the memory block, etc.

In one embodiment, the initial information may include how many times the program-erase cycle (PE cycle) has been performed in the memory block.

In one embodiment, the initial information may include whether memory cells within a memory block have operated as multi-level cells that store two or more bits of data. The initial information may include how many times the memory cells within the memory block have operated as multi-level cells storing two or more bits of data.

In addition, the initial information may further include information on the date the memory device was powered off, information on the EPI time, information on the temperature, etc.

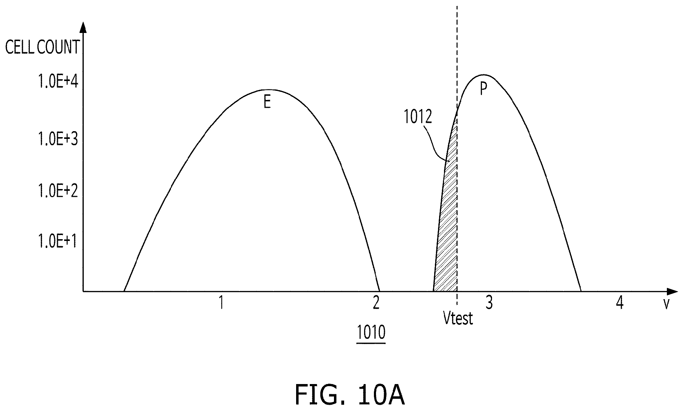

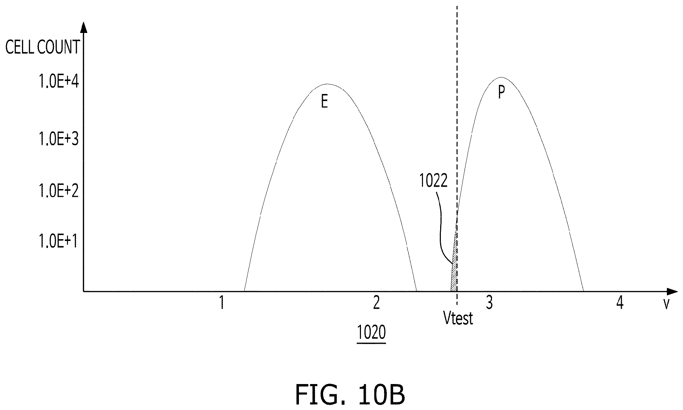

The memory device may carry out a pre-program operation for increasing a threshold voltage of an over-erasing state (otherwise known as an over-erased state) of memory cells at S712. At S713, after performing the pre-program operation, the memory device may obtain a cell count value by counting the number of memory cells programmed in the highest program state, e.g., a program state of a SLC, with a threshold voltage less than or equal to a critical threshold voltage among the memory cells. S712 and S713 will be described in detail with reference to FIGS. 10A and 10B.

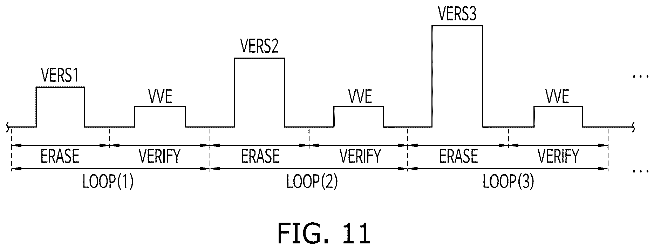

The memory device may perform an erasing operation at S714. After carrying out the erasing operation, the memory device may perform an erasing verification operation to verify whether the erasing operation has been successful at S715. The memory device may determine whether the erasing operation has succeeded based on the erasing verification operation at S716. In response to determining that the erasing operation has failed based on the erasing verification operation, the memory device may perform the erasing operation again at S714. Here, an erasing voltage used for the erasing operation performed again may be a voltage of a higher level than the previous erasing voltage. In contrast, in response to determining that the erasing operation has succeeded based on the erasing verification operation at S716, the memory device may obtain an erase loop count at S717. That is, based on how many times S714 to S716 are implemented (e.g., how many times S714 to S716 are repeated), the erasing operation performed on the memory block may include one or more erase loops, and the memory device may obtain the count of these erase loops as part of a first information. S714 to S717 will be described in detail with reference to FIG. 11.

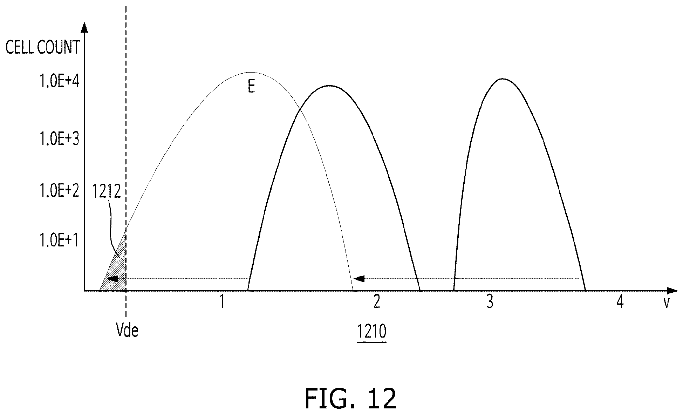

At S718, the memory device may obtain a cell count value by counting the number of memory cells in an erasing state with a threshold voltage lower than or equal to a critical threshold voltage among the memory cells of the memory block. This will be described in detail with reference to FIG. 12.

FIGS. 10A and 10B are views for illustrating S712 and S713 in FIG. 9 in detail. A memory block having the threshold voltage distribution illustrated in FIGS. 10A and 10B may be a single-cell memory block including single level cells (SLCs).

Referring to FIG. 10A, a graph 1010 represents a threshold voltage distribution observed before performing a pre-program on a memory block. A critical threshold voltage Vtest may be a reading level that causes the number of error bits of a program state P of memory cells, for which the pre-program operation has not yet been executed, to become a specific value, e.g., 100. The memory device or the control logic circuit may determine the critical threshold voltage Vtest by performing a reading operation while gradually increasing the reading level and checking for error bits.

The memory device may determine a first cell count value 1012 by counting memory cells in the program state P with a threshold voltage lower than or equal to the critical threshold voltage Vtest.

Referring to FIG. 10B, a graph 1020 represents a threshold voltage distribution observed after performing the pre-program operation on a memory block. Due to the properties of the pre-program operation that increases a threshold voltage of an over-erasing state of memory cells, the threshold voltage of the memory cells may increase overall. For example, compared to the graph 1010 in FIG. 10A, it is seen that the threshold voltage distribution curve on the graph 1020 in FIG. 10B has generally shifted to the right.

After the pre-program operation has been performed, the memory device may determine a second cell count value 1022 by counting memory cells in a program state with a threshold voltage lower than or equal to the critical threshold voltage Vtest among the memory cells in the memory block.

As memory cells are less responsive to the pre-program operation, it may be difficult to complete the program operation by executing only one program loop. That is, as memory cells are less responsive to the pre-program operation, it may be more likely that two or more program loops will be executed when the program operation is performed on a page within a memory block and a fast program operation will fail.

The amount that the second cell count value 1022 decreases relative to the first cell count value 1012 (e.g., the difference between the first cell count value 1012 and the second cell count value 1022) may be indicative of the responsiveness of the memory cells to the pre-program operation. The more that the second cell count value 1022 decreases, the more responsive the memory cells are to the pre-program operation. Therefore, as the second cell count value 1022 decreases, the difference between the first cell count value 1012 in FIG. 10A and the second cell count value 1022 in FIG. 10B increases, or the ratio of the second cell count value to the first cell count value decreases, a fast program operation on a page within a memory block may be less likely to fail.

FIG. 11 is a view for illustrating S714 to S717 in FIG. 9 in detail.

Referring to FIGS. 9 and 11, the erasing operation in S714 to S716 may be an erasing operation by the incremental step pulse erasing (ISPE).

The erasing operation may include one or more erase loops. For example, referring to FIG. 11, the memory device may sequentially perform a plurality of erase loops (LOOP(1), LOOP(2), LOOP(3), ...) until the erasing operation is completed. As the erase loop is repeated, an erase voltage (VERS1, VERS2, VERS3, ...) may be increased stepwise.

Each erase loop LOOP(i) may include an erasing period ERASE and an erasing verification period VERIFY.

Referring to FIGS. 9 and 11, at S714, the memory device may apply erase voltages (VERS1, VERS2, VERS3, ...) to channels and erase allowance voltages to word lines in order to perform an erasing operation for erasing memory cells during the erasing period ERASE.

Referring to FIGS. 9 and 11, at S715, the memory device may apply an erasing verification voltage VVE to a word line in order to perform an erasing verification operation for verifying whether an erasing has been successful during the erasing verification period VERIFY.

Referring to FIGS. 9 and 11, at S716, the memory device may determine whether the conditions for passing the erasing verification operation have been satisfied to determine whether the erasing has succeeded through the erasing verification operation. The memory device may repeat the erasing operation and the erasing verification operation while gradually increasing the erase voltage (VERS1, VERS2, VERS3, ...) until the passing conditions are fulfilled. Here, the passing conditions may mean the maximum allowable number of memory cells that have a threshold voltage higher than the data erasing verification voltage VVE and have not yet been erased among selected memory cells to be erased, and an erase loop may be repeated until the number of the memory cells that have yet to be erased is less than the maximum allowable number. The maximum allowable number may be determined based on the ECC level of a non-volatile memory device.

With reference to FIGS. 9 and 11, the memory device may obtain an erase loop count at S717. For example, when S714 to S716 are repeated three times and the LOOP (1) to LOOP (3) are performed, the memory device may obtain "three" as the erase loop count. The erase loop count may indicate how responsive memory cells are to an erase voltage.

As memory cells are less responsive to an erasing operation, it may be difficult to complete the erasing operation by using only one erase loop. That is, as memory cells are less responsive to an erasing operation, it may be more likely that two or more erase loops will be executed when an erasing operation is performed on a memory block and a fast program operation will fail.

As the erase loop count decreases, memory cells are more responsive to erasing and program operations. Therefore, as the erase loop count decreases, it may be less likely that a fast program operation on a page within a memory block will fail.

FIG. 12 is a view for illustrating S718 in FIG. 9 in detail.

A graph 1210 represents a threshold voltage distribution observed after performing an erasing operation on a memory block. The memory device may obtain a cell count value 1212 by counting memory cells that are in an erasing state E and have a threshold voltage lower than or equal to a critical threshold voltage Vde among memory cells.

The critical threshold voltage Vde may refer to a threshold voltage of an erasing state, in which it is difficult to reach the minimum threshold voltage for being in a program state through a program operation. A memory cell having a threshold voltage below the critical threshold voltage Vde may be referred to as a deep-erased memory cell, and a fast program operation on such a memory cell may be highly likely to fail.

FIG. 13 is a view for illustrating S720 in FIG. 7 in detail.

A storage system, e.g., the storage system 10 in FIG. 1, may determine the first score 822 based on the first information 812 collected in S710 in FIG. 7. Summarizing the embodiments described above with reference to FIGS. 9 to 12, the first information 812 may include an initial information on a memory block 812_1, a cell count value 812_2 in a program state after a pre-program operation on the memory block, the count of erase loops 812_3 performed for the memory block, and a cell count value 812_4 in an erasing state below a critical threshold voltage after an erasing operation on the memory block.

The first score calculator 820 within the storage system may receive the first information 812 and determine the first score 822. In one embodiment, the first score calculator 820 may determine the first score 822 based on at least part of the first information 812.

The first score calculator 820 may assign a higher first score 822 as it determines that a fast program operation performed within a memory block is less likely to fail, that is, the program operation is more likely to succeed using one single program loop for a specific page or word line within the memory block. As the first score 822 determined by the first score calculator 820 is higher, a fast program may be executed more times.

In one embodiment, the first score calculator 820 may assign a higher first score 822 based on the initial information 812_1 when a memory block is not a weak block, compared to when the memory block is a weak block.

In one embodiment, the first score calculator 820 may assign a lower first score 822 when the count of program-erase cycles of the initial information 812_1 corresponds to a second count greater than a first count, compared to when the count of program-erase cycles corresponds to the first count. For example, the count of program-erase cycles and the first score 822 may have an inverse relationship (e.g., may be inversely proportional) under the same conditions. This is because a fast program operation may be more likely to fail because memory cells may become less responsive to a program voltage due to writing and erasing operations, etc., which are frequently performed, as the count of program-erase cycles increases.

In one embodiment, the first score calculator 820 may assign a higher first score 822 based on the initial information 812_1 when each memory cell within a memory block has not operated as a multi-level cell storing two or more bits of data, compared to when each memory cell has a history of operating as a multi-level cell. This is because, when the memory cells have a history of operating as a multi-level cell, a fast program operation may be more likely to fail because the memory cells may become less responsive to a program voltage due to frequent read operations and others.

In one embodiment, as memory cells within a memory block have operated as a multi-level cell less times, the first score calculator 820 may assign a higher first score 822.

In one embodiment, the first score calculator 820 may assign a lower first score 822 as the cell count value 812_2, e.g., the second cell count value 1022 in FIG. 10B, in a program state with a threshold voltage lower than or equal to a critical threshold voltage after a pre-program is higher. This is because, as memory cells are less responsive to a program voltage, the cell count value 812_2 may be higher and a fast program operation may be more likely to fail.

In other embodiments, the first score calculator 820 may assign a higher first score 822 as the ratio of the cell count value 812_2, e.g., the second cell count value 1022 in FIG. 10B, in a program state with a threshold voltage lower than or equal to a critical threshold voltage after a pre-program to the cell count value 812_2, e.g., the first cell count value 1012 in FIG. 10A, in the program state with a threshold voltage lower than or equal to the critical threshold voltage before the pre-program decreases.

In one embodiment, as the count of erase loops 812_3 is higher, the first score calculator 820 may assign a lower first score 822. This is because a fast program operation for pages or word lines within a memory block may be more likely to fail because memory cells may become less responsive to an erase voltage and a program voltage as the count of erase loops 812_3 increases.

In one embodiment, as the cell count value 812_4, e.g., the cell count value 1212 in FIG. 12, in an erasing state below a critical threshold voltage after an erasing operation increases, the first score calculator 820 may assign a lower first score 822. This is because a fast program operation for pages or word lines within a memory block may be more likely to fail because the number of memory cells within the memory block that have difficulty reaching the minimum threshold voltage to be in a program state through a program operation may increase as the cell count value 812_4 increases.

FIG. 14 is a flow chart for illustrating S720 in FIG. 7 in detail. The flow chart in FIG. 14 represents a specific example of the process of determining the first score 822 using the first score calculator 820 in FIG. 13, but the process of determining the first score 822 is not limited thereto.

The first score 822 may be set to an initial value, e.g., 100, at S721. At S722, the first score 822 may be the smaller of the initial value and a value obtained by multiplying the ratio of a cell count value (p_under_ref, e.g., the first cell count value 1012 in FIG. 10A), in a program state with a threshold voltage lower than or equal to a critical threshold voltage before a pre-program to a cell count value (p_under_count, e.g., the second cell count value 1022 in FIG. 10B), in the program state with a threshold voltage lower than or equal to the critical threshold voltage after the pre-program by the initial value and a coefficient, e.g. 0.05. That is, the first score 822 may be updated in proportion to the responsiveness of memory cells to a pre-program operation.

At S723, the first score calculator 820 may determine the first score 822 based on whether a cell count value (E state count), e.g., the cell count value 1212 in FIG. 12, in an erasing state below a critical threshold voltage after an erasing operation exceeds a threshold value.

In response to determining that the cell count value in the erasing state below the critical threshold voltage after the erasing operation exceeds the threshold value, the first score calculator 820 may decrease the first score 822. For example, at S723_1, in response to determining that the cell count value in the erasing state below the critical threshold voltage exceeds the threshold value, the first score calculator 820 may set the first score 822 to zero. When the first score 822 is set to zero, S720 in FIG. 14 may be terminated and the process may proceed to S730 in FIG. 7.

In response to not determining that the cell count value in the erasing state below the critical threshold voltage exceeds the threshold value, the first score calculator 820 may maintain the original (e.g., current or previous) value of the first score 822.

The first score calculator 820 may determine the first score 822 based on whether a memory block corresponds to a weak block at S724.

The first score calculator 820 may decrease the first score 822 in response to a memory block corresponding to a weak block. For example, the first score calculator 820 may set the first score 822 to zero in response to the memory block corresponding to a weak block at S724_1. When the first score 822 is set to zero, S720 in FIG. 14 may be terminated and the process may proceed to S730 in FIG. 7.

In response to the memory block not corresponding to a weak block, the first score calculator 820 may maintain the original (e.g., current or previous) value of the first score 822.

The first score calculator 820 may decrease the first score 822 as the count of program-erase cycles increases. For example, at S725, the first score calculator 820 may update the first score 822 by dividing the first score 822 by the count of program-erase cycles (PE cycle) and multiplying the result by a specific coefficient, e.g., 100.

The first score calculator 820 may determine the first score 822 based on whether each memory cell in a memory block has ever operated as a multi-level cell storing two or more bits of data at S726.

The first score calculator 820 may decrease the first score 822 in response to memory cells in a memory block that have ever operated as a multi-level cell. For example, the first score calculator 820 may divide the first score 822 by a specific value, e.g., 2, in response to determining that the memory cells within the memory block have ever operated as a multi-level cell at S726_1.

In response to the memory cells in the memory block that have not operated as a multi-level cell, the first score calculator 820 may maintain the original (e.g., current or previous) value of the first score 822.

The first score calculator 820 may determine the first score 822 based on whether the number of erase loops included in an erasing operation for a memory block exceeds a threshold number, e.g., 5, at S727.

In response to the number of erase loops included in an erasing operation for a memory block exceeding a threshold number, the first score calculator 820 may decrease the first score 822. For example, in response to the number of the erase loops included in the erase operation for the memory block exceeding the threshold number, the first score calculator 820 may set the first score 822 to zero at S727_1. When the first score 822 has been set to zero, S720 in FIG. 14 may be terminated and the process may proceed to S730 in FIG. 7.

In response to determining that the number of the erase loops does not exceed the threshold number, the first score calculator 820 may maintain the original (e.g., current or previous) value of the first score 822.

The first score calculator 820 may determine the first score 822 based on whether the number of the erase loops included in the erasing operation for the memory block is a predefined value (e.g. "one") at S728.

The first score calculator 820 may decrease the first score 822 in response to the number of the erase loops included in the erasing operation for the memory block not being the predefined value (e.g., "one"). For example, the first score calculator 820 may divide the first score 822 by a specific value, e.g., 2, in response to the number of the erase loops included in the erasing operation for the memory block not being the predefined value (e.g., "one") at S728_1.

The first score calculator 820 may maintain the original (e.g., current or previous) value of the first score 822 in response to the number of the erase loops included in the erasing operation for the memory block being the predefined value (e.g., "one").

The operations of dividing the first score 822 and setting it to a specific value such as "zero" in S720 in FIG. 14 may be replaced with other operations. For example, the operations may be replaced with any one of operations of decreasing the first score 822. For instance, the operations may be any one of the operations of dividing the first score 822 by a specific value, setting it to a specific value lower than the current value, and subtracting a specific value from the first score 822.

The order of the operations in FIG. 14 may be changed. For instance, the order of operations S722-S728 may be changed.

FIG. 15 is a flowchart for illustrating S730 in FIG. 7 in detail. S730 may be performed by a memory device, e.g., the memory device 300_1 in FIG. 2, specifically, a control logic circuit of the memory device, e.g., the control logic circuit 323 in FIG. 2. The information obtained in S731, S733, and S734 in FIG. 15 may be included in the second information on the memory block in S730 in FIG. 7.

The memory device may obtain weak word line (weak WL) information within a memory block at S731. A weak word line may be easily affected by adjacent word lines or memory cells and have poor properties. The weak word line information within a memory block, e.g., the location of a weak word line, etc., may be experimental data, which has been measured and recorded in advance.

The memory device may perform a normal program operation by applying a program voltage and a verification voltage to a selected page within a memory block at S732. For example, the memory device may carry out a normal program operation in response to receiving a command for commanding a normal program operation from the storage controller. The memory device may perform one program loop by applying the program voltage to the selected page and carrying out a verification operation to verify whether a program has been successful by applying the verification voltage to the selected page. Here, when the program has failed, the memory device may re-execute the program loop by reapplying the program voltage and the verification voltage to the page. The memory device may perform a normal program operation by executing one or more program loops.

The memory device may obtain the count of one or more program loops that have been performed for the selected page at S733. For example, the memory device may obtain the count of program loops through a "GetNANDStatus" command.

At S734, the memory device may obtain a cell count value (P state count) by counting memory cells in a program state and with a threshold voltage lower than or equal to a critical threshold voltage among memory cells connected to the selected page. For example, the memory device may obtain the cell count value through a "GetFeature" command.

The order of the operations in FIG. 15 may be changed. In addition or alternatively, some of the operations in FIG. 15 may be performed in parallel to each other.

FIG. 16 is a view for illustrating S734 in FIG. 15 in detail.

A memory block having a threshold voltage distribution as illustrated in FIG. 16 may be a single-cell memory block including single-level cells (SLCs).

The memory device may obtain a cell count value 1612 by counting memory cells in a program state and with a threshold voltage lower than or equal to a critical threshold voltage Vth among memory cells connected to a selected page. The critical threshold voltage Vth may be a voltage corresponding to a level of a verification voltage of a verification operation, and the cell count value 1612 may indicate the number or ratio of memory cells that do not satisfy the criteria for passing the verification operation. As the cell count value 1612 increases, it may be more likely that a fast program operation will fail because the threshold voltage distribution may not move to a desired position when the same voltage is applied to the selected page.

FIG. 17 is a view for illustrating S740 in FIG. 7 in detail.

A storage system, e.g., the storage system 10 in FIG. 1, may determine the second score 832 based on the second information 872 collected in S730 in FIG. 7. The second information 872 may include whether a word line including a selected page is a weak word line 872_1, the count of program loops performed for the selected page 872_2, and a cell count value 872_3 in a program state below a critical threshold voltage after a program operation.

The second score calculator 830 within the storage system may receive the second information 872 and determine the second score 832. In one embodiment, the second score calculator 830 may determine the second score 832 based on at least part of the second information 872.

The second score calculator 830 may assign a higher second score 832 as it determines that a fast program operation is less likely to fail, that is, the program operation is more likely to succeed using one program loop. For example, as the second score 832 determined by the second score calculator 830 increases, a fast program may be performed more times.

In one embodiment, the second score calculator 830 may assign a lower second score 832 when a word line including a selected page is a weak word line than when it is not a weak word line. This is because a fast program operation for the weak word line or a word line adjacent thereto may be more likely to fail due to the low responsiveness of memory cells connected to the weak word line.

In one embodiment, the second score calculator 830 may assign a lower second score 832 as the count of program loops 872_2 performed for a selected page increases. This is because, as the responsiveness to a program voltage decreases, the count of program loops 872_2 may increase and a fast program operation may be more likely to fail.

In one embodiment, the second score calculator 830 may assign a lower second score 832 as the cell count value 872_3 in a program state below a critical threshold voltage after a program operation increases. This is because, as the responsiveness to a program voltage decreases, the cell count value 872_3 may increase and a fast program operation may be more likely to fail.

FIG. 18 is a flow chart for illustrating S740 in FIG. 7 in detail. The flow chart in FIG. 18 represents a specific example of the process of determining the second score 832 using the second score calculator 830 in FIG. 17, but the process of determining the second score 832 is not limited thereto.

The second score 832 may be set to an initial value, e.g., 100, at S741.

The second score calculator 830 may determine the second score 832 based on whether a word line including a selected page for which a normal program operation has been performed corresponds to a weak word line at S742.

In response to the fact that the word line including the selected page for which the normal program operation has been performed corresponds to a weak word line, the second score calculator 830 may decrease the second score 832. For example, in response to the fact that the word line including the selected page for which the normal program operation has been performed corresponds to a weak word line, the second score calculator 830 may set the second score 832 to zero at S743. When the second score 832 is set to zero, S740 in FIG. 18 may be terminated and the process may proceed to S750 in FIG. 7.

In response to the fact that the word line including the selected page for which the normal program operation has been performed does not correspond to a weak word line, the second score calculator 830 may maintain the original (e.g., current or previous) value of the second score 832.

The second score calculator 830 may determine the second score 832 based on whether the count of program loops performed on a selected page is equal to or greater than a threshold count at S744.

The second score calculator 830 may decrease the second score 832 in response to the fact that the count of the program loops performed on the selected page is equal to or greater than the threshold count, e.g., 2 times. For example, at S745, the second score calculator 830 may set the second score 832 to zero in response to the fact that the count of the program loops performed on the selected page is equal to or greater than the threshold count. When the second score 832 is set to zero, S740 in FIG. 18 may be terminated and the process may proceed to S750 in FIG. 7.

The second score calculator 830 may maintain the original (e.g., current or previous) value of the second score 832 in response to the fact that the count of the program loops performed on the selected page is below the threshold count.

At S746 and S748, the second score calculator 830 may determine the second score 832 based on a cell count value obtained by counting memory cells in a program state and with a threshold voltage lower than or equal to a critical threshold voltage among memory cells connected to a selected page.

For example, at S747, in response to the obtained cell count value being less than a first threshold value, e.g., three percent of the total cell count value in a program state, the second score calculator 830 may finally assign the second score 832 as an initial value.

At S748_1, in response to the obtained cell count value being equal to or greater than the first threshold value and less than a second threshold value, e.g., seven percent of the total cell count value in the program state, which is greater than the first threshold value, the second score calculator 830 may finally assign the second score 832 as a value obtained by dividing the initial value by a specific value. e.g., 50.

At S748_2, in response to the obtained cell count value being equal to or greater than the second threshold value, the second score calculator 830 may assign the second score 832 as a value lower than the value determined in S748_1, e.g., 0.

The order of some of the operations of FIG. 18 may be varied. For instance, the order of steps S742 and 744 may be varied.

In FIG. 18, the second score 832 is determined by classifying the cell count value into one of three ranges in S746 and S748, but the present disclosure is not limited to this embodiment. For example, the cell count value may be classified into one of any number of multiple ranges, and the second score 832 as a score corresponding to the range may be assigned.

The operations of dividing the second score 832 and setting it to a specific value such as "zero" in S740 in FIG. 18 may be replaced with other operations. For example, the operations may be replaced with any one of operations of decreasing the second score 832. For instance, the operations may be any one of the operations of dividing the second score 832 by a specific value, setting it to a specific value lower than the current value, and subtracting a specific value from the second score 832.

FIG. 19 is a view for illustrating S750 in FIG. 7 in detail.

In one embodiment, the third score calculator 840 may determine the total score 842 based on the first score 822 and the second score 832. For instance, the third score calculator 840 may determine the total score 842 as a combination (e.g., aggregation) of the first score 822 and the second score 832. For example, the third score calculator 840 may determine that the sum of the first score 822 and the second score 832 is the total score 842. In another embodiment, the third score calculator 840 may determine that the weighted sum of the first score 822 and the second score 832 is the total score 842. As an example, the weight applied to each of the first score 822 and the second score 832 may be any value in the range of zero to one. The sum of the weights applied to each of the first score 822 and the second score 832 may be one.

The mode selector 850 may determine the fast program count 852 based on the total score 842.

On the other hand, the third score calculator 840 and the mode selector 850 may be formed as one single module, and the single module may receive the first score 822 and the second score 832 and immediately determine and output the fast program count 852.

FIG. 20 is a flowchart for illustrating S750 in FIG. 7 in detail. S750 may be performed by the third score calculator 840 and the mode selector 850.

The third score calculator 840 may determine the total score 842 at S751.

The mode selector 850 may determine which of multiple ranges the total score 842 falls within at S752, S754, and S756. The mode selector 850 may determine the fast program count 852 corresponding to the range in which the total score 842 falls, from among a plurality of skipping count candidates corresponding to the multiple ranges at S753, S755, and S757. The plurality of candidates for skipping count may include a skip count determined based on the number of string selection lines, e.g., SSL1 to SSL3 in FIG. 4, of a memory cell array.

For example, at S753, in response to the total score 842 being the possible maximum score, the mode selector 850 may determine the fast program count 852 by subtracting one from a multiple, e.g., two times, of the number of string selection lines. This can be understood as follows: It is assumed that a plurality of pages corresponding to a multiple of the number of the string selection lines, including a page on which a normal program has been performed to determine the second score (that is, a plurality of pages in a word line including the page for which the normal program has been performed and word lines adjacent thereto), have similar properties, and a fast program operation may be carried out on such pages.

At S755, in response to the total score 842 being less than the possible maximum score and equal to or greater than a first threshold, the mode selector 850 may determine the fast program count 852 by subtracting one from the number of the string selection lines. This can be understood as follows: It is assumed that a plurality of pages corresponding to the number of the string selection lines, including the page on which the normal program has been performed to determine the second score (that is, a plurality of pages in the word line including the page on which the normal program has been performed), have similar properties, and the fast program operation may be carried out on such pages.

At S757, in response to the total score 842 being less than the first threshold and equal to or greater than a second threshold, the mode selector 850 may determine the fast program count 852 by subtracting one from half the number of the string selection lines. This can be understood as follows: It is assumed that a plurality of pages corresponding to half the number of the string selection lines, including the page on which the normal program has been performed to determine the second score (that is, half the plurality of pages in the word line including the page on which the normal program has been performed), have similar properties, and the fast program operation may be carried out on such pages. The first threshold may be less than the maximum score and greater than the second threshold.

In response to the total score 842 being less than the second threshold, the mode selector 850 may determine that the fast program count 852 is zero at S758. That is, because there is a high possibility that the fast program operation will fail multiple times, it may be determined to perform the normal program operation on multiple pages within a corresponding memory block and not perform the fast program operation.

Hereinafter, various embodiments of the present disclosure will be described by summarizing the embodiments described with reference to FIGS. 13 to 20.

In one embodiment, a control logic circuit, e.g., the control logic circuit 323 in FIG. 2, may perform a pre-program operation to increase a threshold voltage of an over-erasing state of memory cells, and may obtain a cell count value by counting memory cells programmed with a threshold voltage lower than or equal to a critical threshold voltage among memory cells after the pre-program operation. A storage system, e.g., the storage system 10 in FIG. 1, may determine that a fast program count, e.g., the number of pages for which a verification procedure is to be skipped, corresponds to a specific value in response to the obtained cell count value being a first value, and may determine that the fast program count corresponds to a value less than the specific value in response to the cell count value being a second value greater than the first value. That is, the fast program count may be determined such that it is lower in response to the cell count value being higher (e.g., such that the fast program count and the cell count value have an inverse relationship).

In one embodiment, a control logic circuit, e.g., the control logic circuit 323 in FIG. 2, may obtain a cell count value by counting memory cells in an erasing state and with a threshold voltage lower than or equal to a critical threshold voltage among memory cells, and a storage system, e.g., the storage system 10 in FIG. 1, may determine that a fast program count corresponds to a specific value in response to a cell count value being a first value and determine that the fast program count corresponds to a value less than the specific value in response to the cell count value being a second value greater than the first value. That is, the fast program count may be determined such that it is lower in response to the cell count value being higher (e.g., such that the fast program count and the cell count value have an inverse relationship).

In one embodiment, a control logic circuit, e.g., the control logic circuit 323 in FIG. 2, may perform an erasing operation including one or more erase loops for a memory block, and a storage system, e.g., the storage system 10 in FIG. 1, may determine that a fast program count corresponds to a specific value in response to the count of the one or more erase loops being a first value and determine that the fast program count corresponds to a value less than the specific value in response to the count of the one or more erase loops being a second value greater than the first value. That is, the fast program count may be determined such that it is lower in response to the count of the one or more erase loops being higher (e.g., such that the fast program count and the count of the one or more erase loops have an inverse relationship).

In one embodiment, a storage system, e.g., the storage system 10 in FIG. 1, may determine that a fast program count corresponds to a specific value in response to determining that a memory block is a weak block, and may determine that the fast program count corresponds to a value greater than the specific value in response to determining that the memory block is not a weak block. That is, the fast program count may be determined such that it is lower for a weak block than for a block that is not a weak block.

In one embodiment, a storage system, e.g., the storage system 10 in FIG. 1, may determine that a fast program count corresponds to a specific value in response to the count of program-erase cycles being a first value, and may determine that the fast program count corresponds to a value less than the specific value in response to the count of program-erase cycles being a second value greater than the first value. That is, the fast program count may be determined such that it is lower in response to the count of program-erase cycles being higher (e.g., such that the fast program count and the count of program erase cycles have an inverse relationship).

In one embodiment, a storage system, e.g., the storage system 10 in FIG. 1, may determine that a fast program count corresponds to a first value in response to determining that memory cells have previously (e.g., ever) operated as a multi-level cell, and may determine that the fast program count corresponds to a second value greater than the first value in response to determining that the memory cells have not previously (e.g., never) operated as a multi-level cell. That is, the fast program count may be determined such that it is lower for memory cells that have previously operated as multi-level cells than for memory cells that have not previously operated as multi-level cells.

In one embodiment, a control logic circuit, e.g., the control logic circuit 323 in FIG. 2, may perform one or more program loops for a selected page among a plurality of pages, and a storage system, e.g., the storage system 10 in FIG. 1, may determine that a fast program count corresponds to a specific value in response to the count of the one or more program loops being a first value and determine that the fast program count corresponds to a value less than the specific value in response to the count of the one or more program loops being a second value greater than the first value. That is, the fast program count may be determined such that it is lower in response to the count of the one or more program loops being higher (e.g., such that the fast program count and the count of the one or more program loops have an inverse relationship). A program operation corresponding to the fast program count may be a program operation to be performed following a program operation for the selected page.

In one embodiment, a control logic circuit, e.g., the control logic circuit 323 in FIG. 2, may perform a program operation on a selected page among a plurality of pages, and may obtain a cell count value by counting memory cells in a program state and with a threshold voltage lower than or equal to a critical threshold voltage among memory cells connected to the selected page. A storage system, e.g., the storage system 10 in FIG. 1, may determine that a fast program count corresponds to a particular value in response to the obtained cell count value being a first value, and may determine that the fast program count corresponds to a value less than the particular value in response to the obtained cell count value being a second value greater than the first value. That is, the fast program count may be determined such that it is lower in response to the obtained cell count being higher (e.g., such that the fast program count and the obtained cell count have an inverse relationship). A program operation corresponding to the fast program count may be a program operation to be performed following a program operation for the selected page.

One or more of the embodiments described in preceding paragraphs may be combined. For instance, the fast program count may be determined such that it has an inverse relationship with one or more of: a first cell count obtained by counting memory cells programmed with a threshold voltage lower than or equal to a first critical threshold voltage after the pre-program operation; a second cell count cell obtained by counting memory cells in an erased state with a threshold voltage lower than or equal to a second critical threshold voltage after an erase operation; a count of one or more erase loops; a count of program-erase cycles; a count of program loops; and third cell count obtained by counting memory cells having a threshold voltage lower than or equal to a third critical threshold voltage among memory cells connected to a selected page on which a program operation has been performed. In addition or alternatively, the fast program count may be lower in response to one or both of: the block being a weak block; and the memory cells having previously been multi-level cells.

In one embodiment, a storage system, e.g., the storage system 10 in FIG. 1, may determine that a fast program count is zero in the current program-erase cycle in response to a fast program count determined based on a selected page among a plurality of pages being zero in a program-erase cycle performed prior to obtaining information on a memory block.

In one embodiment, a control logic circuit, e.g., the control logic circuit 323 in FIG. 2, may perform a program operation by applying a program voltage and a verification voltage to a selected page in the current program-erase cycle in response to a program operation performed without carrying out a verification procedure for a selected page among a plurality of pages in a program-erase cycle performed prior to obtaining information on a memory block.

In one embodiment, a storage system, e.g., the storage system 10 in FIG. 1, may determine that a fast program count is lower than or equal to a predetermined threshold, e.g., 50 times. That is, the storage system may force a normal program operation every certain number of times.

In one embodiment, a storage system, e.g., the storage system 10 in FIG. 1, may flexibly adjust a fast program count based on the capacity of a single-level cell (SLC) cache and the capacity of a triple-level cell (TLC) cache.

In one embodiment, a storage system, e.g., the storage system 10 in FIG. 1, may update a score by performing a fast program operation for only some of a fast program count and performing a normal program operation for the others thereof. For example, the storage system may recompute a score based on information obtained by performing the normal program operation and use the recomputed score to determine a fast program count. In one example, the storage system may update the fast program count only when the determined (e.g., new) fast program count is less than the existing (e.g., previous) fast program count.

A control logic circuit, e.g., the control logic circuit 323 in FIG. 2, may receive information on a fast program count determined according to various embodiments described above, may perform a program operation by applying a program voltage to and skipping a verification procedure for each page corresponding to the fast program count, and may carry out a program operation by applying a program voltage and a verification voltage to a page on which a program operation is to be performed following the pages corresponding to the fast program count.

FIG. 21 is a view for illustrating S760 in FIG. 7 in detail. FIG. 21 shows program operations performed on pages PG1 to PG11.

A fast program operation may be performed on pages corresponding to a determined fast program count. For example, it may be determined that the fast program count is two based on information obtained from a normal program operation performed for PG1, so that fast program operations for PG2 and PG3 may be carried out.

Then, a normal program operation may be carried out on PG4, which is a page on which a program operation is to be performed following the pages corresponding to the fast program count, and it may be determined that the fast program count is five based on information obtained from the normal program operation performed for PG4 so that fast program operations for PG5 to PG9 may be carried out.

Thereafter, a normal program operation may be carried out on PG10, which is a page on which a program operation is to be performed following the pages corresponding to the fast program count, and it may be determined that the fast program count is zero based on information obtained from the normal program operation performed for PG10 so that a normal program operation may be carried out on PG11.

As a result, it may be possible to minimize the failure of program operations by flexibly adjusting a fast program count according to the various embodiments described above while shortening the time for executing programs for memory blocks. Accordingly, the writing speed of the memory device may be improved, and the throughput thereof may be increased. In addition, power consumption required to perform program operations may be reduced, and the stress applied to memory cells may decrease, thereby extending the life of the memory device.

One or more of the components disclosed herein may include or be implemented by a processor circuit such as hardware including logic circuitry, hardware such as a processor executing software, or a combination thereof. For example, the processor circuit may include a central processing unit (CPU), an arithmetic logic unit (ALU), a digital signal processor, a microcomputer, a field programmable gate array (FPGA), a system on chip (SoC), a programmable logic device, a microprocessor, an application-specific integrated circuit (ASIC), etc., but the present disclosure is not limited thereto.

The present disclosure is not limited to the above-described embodiments and the attached drawings. Various substitutions, modifications, and changes can be made to the present disclosure by a person having ordinary skill in the art within the scope of the technology of the present disclosure, and should be deemed to fall within the scope of the present disclosure. For example, one or more steps of a process described with reference to each of the flowcharts in some drawings may be skipped, the order of the steps of a process may be changed, one or more steps may be performed simultaneously, or one or more steps may be repeated multiple times.

## Claims

1. A storage device comprising:
a memory device (300_1) comprising a control logic circuit (323), and a memory cell array (321) comprising a memory block having a plurality of pages to which memory cells are connected; and
a storage controller (200) configured to:
obtain information on the memory block;
determine, based on the obtained information on the memory block, a number of pages on which a first program operation for skipping a verification procedure is to be performed; and
transmit a first program command for the first program operation to the memory device (300_1),
wherein the memory device (300_1) is configured to:
receive the first program command from the storage controller (200); and
perform, for a page indicated by the first program command among the plurality of pages, the first program operation by executing one program loop for skipping a verification procedure.

2. The storage device as claimed in claim 1, wherein
the storage controller (200) is further configured to transmit, to the memory device (300_1), a second program command for a second program operation on a page to be programmed next in sequence, in response to the completion of the first program operation corresponding to the determined number of pages, and
the memory device (300_1) is further configured to:
receive the second program command from the storage controller (200); and
perform the second program operation by executing one or more program loops for applying a program voltage and a verification voltage to the page to be programmed next,
wherein the storage controller (200) is further configured to:
update the number of pages based on information on the page on which the second program operation has been performed; and
transmit, to the memory device (300_1), a third program command for the first program operation on pages corresponding to the updated number of pages,
wherein the memory device (300_1) is further configured to perform the first program operation on a page indicated by the third program command, and
wherein the storage controller (200) is further configured to update the number of pages only when a decrease in the number of pages is detected.

3. The storage device as claimed in claim 1 or claim 2, wherein
the memory device (300_1) is further configured to:
perform a pre-program operation that increases a threshold voltage of an over-erasing state of the memory cells;
obtain a cell count value by counting memory cells programmed with a threshold voltage lower than or equal to a critical threshold voltage among the memory cells after the pre-program operation; and
transmit the cell count value to the storage controller (200),
the information on the memory block comprises the cell count value, and
the storage controller (200) is further configured to:
determine the number of pages to be a first number, in response to the cell count value being a first value; and
determine the number of pages to be a second number less than the first number, in response to the cell count value being a second value greater than the first value.

4. The storage device as claimed in claim 1 or claim 2, wherein
the memory device (300_1) is further configured to:
perform an erasing operation on the memory block;
obtain a cell count value by counting memory cells in an erasing state with a threshold voltage lower than or equal to a critical threshold voltage among the memory cells; and
transmit the cell count value to the storage controller (200),
the information on the memory block comprises the cell count value, and
the storage controller (200) is further configured to:
determine the number of pages to be a first number, in response to the cell count value being a first value; and
determine the number of pages to be a second number less than the first number, in response to the cell count value being a second value greater than the first value.

5. The storage device as claimed in claim 1 or claim 2, wherein
the memory device (300_1) is further configured to:
perform an erasing operation by executing one or more erase loops for the memory block; and
transmit, a count of the one or more erase loops, to the storage controller (200),
the information on the memory block comprises the count of the one or more erase loops, and
the storage controller (200) is further configured to:
determine the number of pages to be a first number, in response to the count of the one or more erase loops being a first value; and
determine the number of pages to be a second number less than the first number, in response to the count of the one or more erase loops being a second value greater than the first value.

6. The storage device as claimed in claim 1 or claim 2, wherein
the information on the memory block comprises whether the memory block is a weak block in which an increase rate of an error bit is greater than a threshold increase rate during a program-erase cycle of the memory block, and
the storage controller (200) is further configured to:
determine the number of pages to be a first number, in response to determining that the memory block is the weak block; and
determine the number of pages to be a second number greater than the first number, in response to determining that the memory block is not the weak block.

7. The storage device as claimed in claim 1 or claim 2, wherein
the information on the memory block comprises a count of the program-erase cycles performed for the memory block, and
the storage controller (200) is further configured to:
determine the number of pages to be a first number, in response to the count of the program-erase cycles being a first value; and
determine the number of pages to be a second number less than the first number, in response to the count of the program-erase cycles being a second value greater than the first value.

8. The storage device as claimed in claim 1 or claim 2, wherein
the information on the memory block comprises whether each of the memory cells in the memory block has ever operated as a multi-level cell storing two or more bits of data, and
the storage controller (200) is further configured to:
determine the number of pages to be a first number, in response to determining that the memory cells have ever operated as a multi-level cell; and
determine the number of pages to be a second number greater than the first number, in response to determining that the memory cells have never operated as a multi-level cell.

9. The storage device as claimed in claim 1 or claim 2, wherein
the storage controller (200) is further configured to transmit, to the memory device, a second program command for a second program operation for a selected page among the plurality of pages,
the memory device (300_1) is further configured to:
receive the second program command from the storage controller; and
perform the second program operation by executing one or more program loops for applying a program voltage and a verification voltage to the selected page,
the information on the memory block comprises the count of the one or more program loops executed for the selected page,
the storage controller (200) is further configured to:
determine the number of pages to be a first number, in response to the count of the one or more program loops being a first value; and
determine the number of pages to be a second number less than the first number, in response to the count of the one or more program loops being a second value greater than the first value, and
the first program operation is a program operation to be performed following the second program operation for the selected page.

10. The storage device as claimed in claim 1 or claim 2, wherein
the storage controller (200) is further configured to transmit, to the memory device (300_1), a second program command for a second program operation for a selected page among the plurality of pages,
the memory device (300_1) is further configured to:
receive the second program command from the storage controller (200);
perform the second program operation by executing one or more program loops for applying a program voltage and a verification voltage to the selected page;
obtain a cell count value by counting memory cells having a threshold voltage lower than or equal to a critical threshold voltage among memory cells connected to the selected page on which the second program operation has been performed; and
transmit the cell count value to the storage controller (200),
the information on the memory block comprises the cell count value,
the storage controller (200) is further configured to:
determine the number of pages to be a first number, in response to the cell count value being a first value; and
determine the number of pages to be a second number less than the first number, in response to the cell count value being a second value greater than the first value, and
the first program operation is a program operation to be performed following the second program operation for the selected page.

11. The storage device as claimed in any preceding claim, wherein,
in response to determining that the number of pages on which the first program operation is to be performed is zero based on a first page among the plurality of pages in a first program-erase cycle performed prior to obtaining the information on the memory block, the storage controller (200) is further configured to transmit, to the memory device (300_1), a second program command for a second program operation for the first page during a second program-erase cycle, and
the memory device (300_1) is further configured to:
receive the second program command from the storage controller (200); and
perform the second program operation by executing one or more program loops for applying a program voltage and a verification voltage to the first page, wherein:
a second page among the plurality of pages is a page to be programmed following the first page in the second program-erase cycle,
the storage controller (200) is further configured to:
transmit, to the memory device (300_1), a third program command for the second program operation for the second page in the second program-erase cycle; and
determine a number of pages on which the first program operation is to be performed in the second program-erase cycle based on the obtained information on the memory block, in response to determining that the number of pages on which the first program operation is to be performed is one or more based on the second page in the first program-erase cycle,
the memory device (300_1) is further configured to:
receive the third program command from the storage controller (200); and
perform the second program operation for the second page, and
the first program operation to be the number of pages determined based on the information on the memory block is performed following the second program operation for the second page.

12. The storage device as claimed in any preceding claim, wherein,
in response to the first program operation being performed for the selected page among the plurality of pages in a first program-erase cycle performed prior to obtaining the information on the memory block, the storage controller (200) is further configured to transmit, to the memory device (300_1), a second program command for a second program operation for the selected page during a second program-erase cycle, and
the memory device (300_1) is further configured to:
receive the second program command from the storage controller (200); and
perform a second program operation by executing one or more program loops for applying a program voltage and a verification voltage to the selected page.

13. The storage device as claimed in any preceding claim, wherein the number of pages is one of a plurality of candidates for skipping count, and the plurality of candidates for skipping count comprise a skipping count determined based on the count of string selection lines of the memory cell array (321).

14. A storage device comprising:
a memory device (300_1) comprising a memory cell array (321) comprising a memory block having a plurality of pages to which memory cells are connected and a control logic circuit (323); and
a storage controller (200) configured to transmit, to the memory device (300_1), a program command for a program operation for each of the plurality of pages,
wherein the memory device (300_1) is configured to:
obtain information on the memory block;
determine, based on the information on the memory block, a number of pages on which a program operation for skipping a verification procedure is to be performed;
receive the program command from the storage controller (200); and
perform, for pages corresponding to the number of pages and indicated by the program command, the program operation by executing one program loop for skipping a verification procedure.

15. An operating method of a storage system comprising a memory device (300_1) comprising a memory cell array (321) comprising a memory block having a plurality of pages and a control logic circuit (323), a storage controller (200) exchanging data with the memory device (300_1), and a host device (20) exchanging data with the storage controller (200), the method comprising:
obtaining information on the memory block by the storage system;
determining, by the storage system, based on the obtained information on the memory block, the number of pages on which a program operation for skipping a verification procedure is to be performed;
transmitting, by the storage controller (200), a program command for a program operation for each of the plurality of pages to the memory device (300_1);
receiving the program command by the memory device (300_1); and
performing, by the memory device (300_1), for pages corresponding to the number of pages and indicated by the program command, the program operation by executing one program loop for skipping a verification procedure.
